(19) **Europäisches Patentamt**
**European Patent Office**
**Office européen des brevets**

(11) **EP 4 779 329 A1**

(12) **EUROPEAN PATENT APPLICATION**
published in accordance with Art. 153(4) EPC

(43) Date of publication:
**22.07.2026 Bulletin 2026/30**

(51) International Patent Classification (IPC):
*G01R 31/08* (2020.01)

(21) Application number: 23798820.9

(22) Date of filing: 15.09.2023

(52) Cooperative Patent Classification (CPC):
**G01R 31/085; G01R 31/088**

(86) International application number:
**PCT/ES2023/070559**

(87) International publication number:
**WO 2025/056820 (20.03.2025 Gazette 2025/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: Ingeteam Power Technology, S.A.
48170 Zamudio (Bizkaia) (ES)

(72) Inventors:
• **GARCÍA ESPINOSA, Juan María**
48170 Zamudio (ES)
• **SAN SEBASTIAN AURRE, Iker**
48170 Zamudio (ES)

(74) Representative: **Balder IP Law, S.L.**
**Paseo de la Castellana 93**
**5ª planta**
**28046 Madrid (ES)**

(54) **METHOD AND DISTANCE UNIT FOR CALCULATING DISTANCE TO FAULT IN A LINE OF AN ELECTRIC POWER SYSTEM**

(57) The invention relates to a computer-implemented method for determining a distance at which a fault occurs in a protected power line of an electric power system, wherein the power line is protected from a weak end of the power line, comprising: measuring the following magnitudes at a measurement point (85) of the protected line from a weak end where the fault occurs: phase A current at the measurement point ($I_a$), phase B current at the measurement point ($I_b$), phase C current at the measurement point ($I_c$), phase A voltage at the measurement point ($V_a$), phase B voltage at the measurement point ($V_b$) and phase C voltage at the measurement point ($V_c$); based on the previous measurements, calculating the following magnitudes of the power line: homopolar sequence voltage at the measurement point ($V_0$), direct sequence voltage at the measurement point ($V_1$), reverse sequence voltage at the measurement point ($V_2$), homopolar sequence current at the measurement point ($I_0$), direct sequence current at the measurement point ($I_1$), reverse sequence current at the measurement point ($I_2$), equivalent voltage ($V_{eq}$), equivalent current ($I_{eq}$) and polarisation voltage ($V_{pol}$); calculating the distance $p$ at which a single-phase, two-phase or three-phase fault occurs in the protected power line. Unit of measurement the method uses.

**FIG. 10**

**Description**

**FIELD OF THE INVENTION**

The present invention relates to the power electronics sector and, more specifically, to units for calculating distance to a fault used in protection and/or location equipment for electric power systems.

**PRIOR STATE OF THE ART**

In electric power systems, such as alternating current (AC) systems, it is necessary to identify - in order to subsequently correct or eliminate - faults that may occur (such as short circuits or ground faults), as they represent anomalous behaviours that can damage equipment and put the health of users or operators at risk. Locating the fault is a necessary step for the subsequent elimination thereof.

Electric power systems are usually equipped with protective equipment. The protective equipment is responsible for responding to short circuits that occur on a specific power line. To do so, it is essential to locate the point in the network where the short circuit has occurred. In other words, when a short circuit occurs, it is necessary to determine whether it has occurred in the direction of the line being covered (forward fault) or in the opposite direction (backward fault) and the distance at which it has occurred from the measurement point. Short circuits (in general, faults) can be single-phase (short circuit between a phase and ground), two-phase (short circuit between two phases), two-phase to ground (short circuit between two phases and ground) or three-phase (short circuit between three phases).

To simplify the analysis of asymmetric (single-phase, two-phase and two-phase to ground) and symmetric (three-phase) faults, so-called sequence networks are used. Sequence networks generally break down an asymmetric network into three symmetric networks (homopolar sequence network, direct sequence network and reverse sequence network).

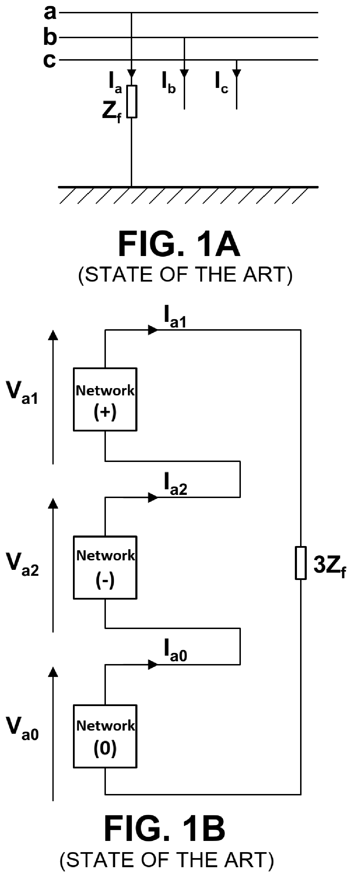

In the case of single-phase faults, in order for the asymmetric system to be equivalent to the three symmetrical sequence networks, the three sequence networks are connected in series, as shown in Figures 1A and 1B. Figure 1A shows a three-phase system (phases a, b, c) in which a fault has occurred in phase "a" (single-phase fault). The currents $I_a$ $I_b$ $I_c$ represent the current of phases a, b, c at the measurement point, respectively. The fault in phase "a" is represented by the fault impedance $Z_f$ that joins phase "a" to ground. Figure 1B shows the three sequence networks connected in series: Network(+) represents the direct sequence network of the system up to the fault point. Voltage $V_{a1}$ is the direct sequence voltage of the system up to the fault point. Current $I_{a1}$ is the direct sequence current of the fault current. Network(-) represents the reverse sequence network of the system up to the fault point. Voltage $V_{a2}$ is the reverse sequence voltage of the system up to the fault point. Current $I_{a2}$ is the reverse sequence current of the fault current. Network(0) represents the homopolar sequence network of the system up to the fault point. Voltage $V_{a0}$ is the homopolar sequence voltage of the system up to the fault point. Current $I_{a0}$ is the homopolar sequence current of the fault current. $3Z_F$ represents the resistance at the fault point that connects the fault phase to ground. This fault current is 3 times the current $I_{a0}$, and thus the "3" is represented by multiplying the same by the fault resistance $Z_f$ so that the sequence networks connected in series represent the asymmetric network.

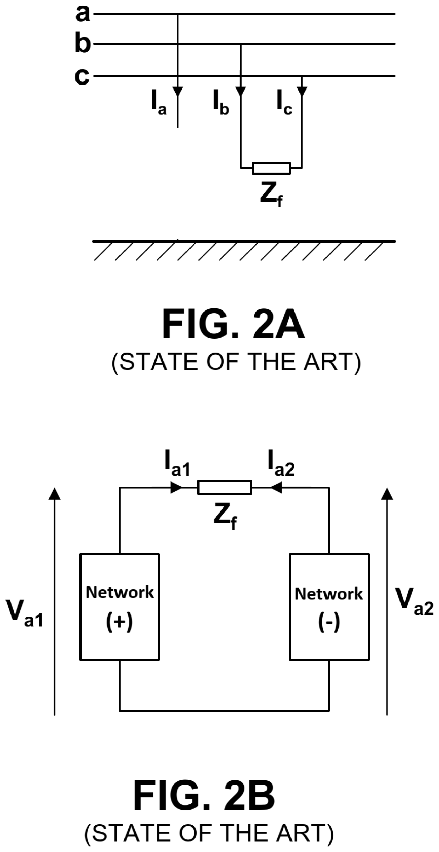

In the case of two-phase faults, the homopolar sequence network is null. The direct and reverse sequence networks are connected in parallel, as shown in Figures 2A and 2B. Figure 2A shows a three-phase system (phases a, b, c) in which a fault has occurred in two phases: "b" and "c" (two-phase fault). The currents $I_a$ $I_b$ $I_c$ represent the current of phases a, b, c at the measurement point, respectively. The two-phase fault is represented by the fault impedance $Z_f$, which joins phase "b" to phase "c". Figure 2B shows the two sequence networks connected in parallel: Network(+) represents the direct sequence network of the system up to the fault point. Voltage $V_{a1}$ is the direct sequence voltage of the system up to the fault point. Current $I_{a1}$ is the direct sequence current of the fault current. Network(-) represents the reverse sequence network of the system up to the fault point. Voltage $V_{a2}$ is the reverse sequence voltage of the system up to the fault point. Current $I_{a2}$ is the reverse sequence current of the fault current. Fault resistance $Z_f$ is the resistance that joins the two fault phases.

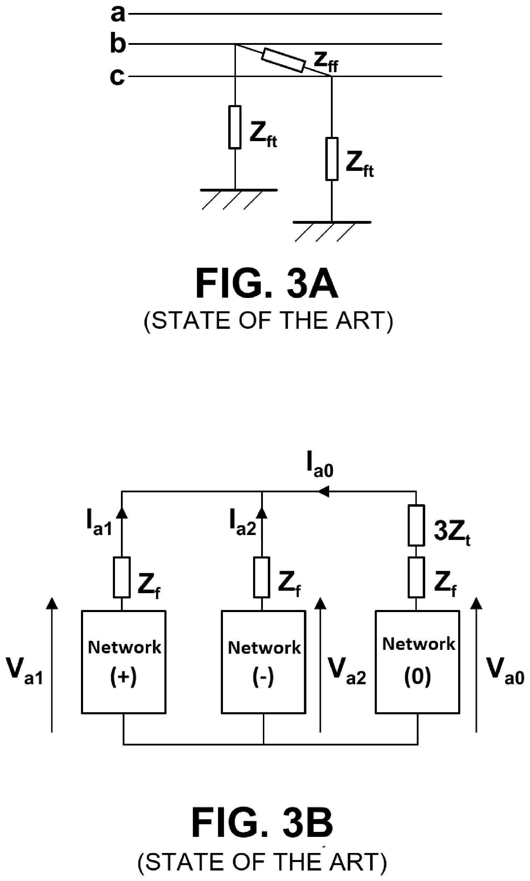

In the case of two-phase ground faults, the three sequence networks are connected in parallel. Figure 3A shows a three-phase system (phases a, b, c) in which a two-phase ground fault has occurred in phases "b" and "c". Impedance $Z_{ff}$ represents the fault resistance between phases "b" and "c". Impedance $Z_{ft}$ represents the resistance between phase "b" and ground and the resistance between phase "c" and ground. Figure 3B shows the three sequence networks connected in parallel: Network(+) represents the direct sequence network of the system up to the fault point. Voltage $V_{a1}$ is the direct sequence voltage of the system up to the fault point. Current $I_{a1}$ is the direct sequence current of the fault current. Network(-) represents the reverse sequence network of the system up to the fault point. Voltage $V_{a2}$ is the reverse sequence voltage of the system up to the fault point. Current $I_{a2}$ is the reverse sequence current of the fault current. Network(0) represents the homopolar sequence network of the system up to the fault point. Voltage $V_{a0}$ is the homopolar sequence voltage of the system up to the fault point. Current $I_{a0}$ is the homopolar sequence current of the fault current.

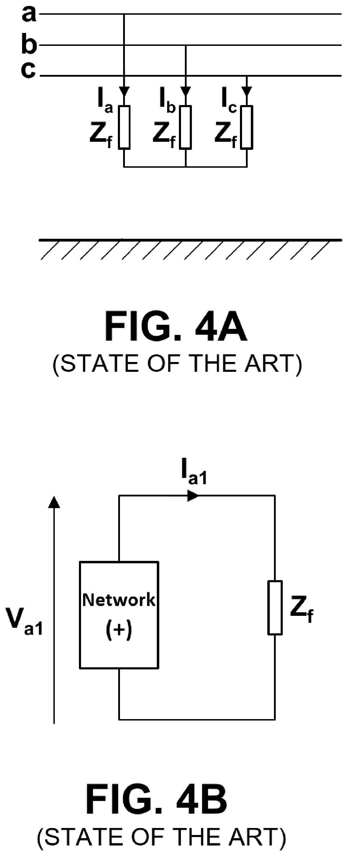

In the case of balanced three-phase faults, only the direct sequence network exists. Figure 4A shows a three-phase system (phases a, b, c) in which a balanced three-phase fault has occurred. The currents $I_a$ $I_b$ $I_c$ represent the current of phases a, b, c at the measurement point, respectively. The balanced three-phase fault is represented by the fault impedance $Z_f$. Figure 4B shows the direct sequence network: Network(+) represents the direct sequence network of the system up to the fault point. Voltage $V_{a1}$ is the direct sequence voltage of the system up to the fault point. Current $I_{a1}$ is the direct sequence current of the fault current.

The distance from the measurement point to where the short circuit has occurred can be calculated using sequence networks, given that the distance to the fault is proportional to the impedance from the measurement point to the fault point.

In protective equipment, the unit responsible for determining the distance at which the fault has occurred is commonly called the distance unit. The distance unit is located at one end of the line being protected. The distance unit plays a key role in the quality of the protective equipment in which it is integrated. It should be noted that the distance is proportional to the measured impedance, and thus the impedance calculation represents the distance to the fault. The distance to the fault is normally measured in values per unit (p). The measurement point is the point from which the voltage and currents are measured to calculate the distance. There are different types of distance units. Among the most popular is the quadrilateral distance unit, named so because the characteristic is a four-sided polygon. In the quadrilateral characteristic it is necessary to work with the reactance measurement and the resistance measurement of the impedance.

A distance unit determines the impedance at which a fault has occurred by dividing the voltage by the current on the protected line when a fault occurs. Impedance is a complex number in which the real part represents the fault resistance and the imaginary part represents the fault reactance. The quadrilateral distance function consists of a characteristic in which the inductive range and resistive range need to be adjusted. The distance function is traditionally measured in Ohms ($\Omega$, measurement of impedance, to which the distance to the fault is proportional).

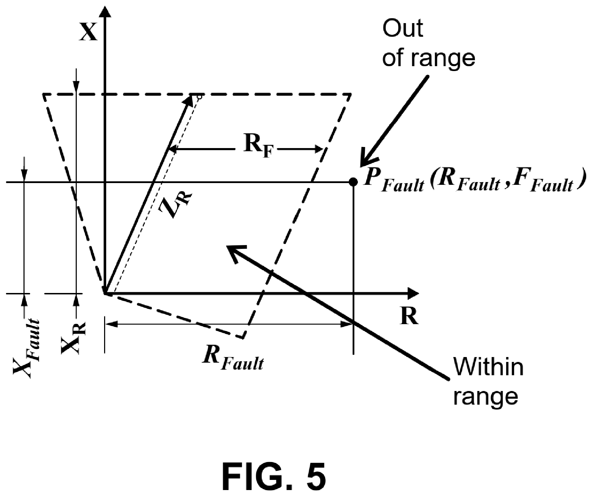

The quadrilateral distance function works in a plane wherein the X-axis represents the fault resistance and the Y-axis represents the fault reactance. The distance therefore has two dimensions, as illustrated by way of example in Figure 5: a resistive dimension (normally represented on the X- or abscissa axis) and an inductive dimension (normally represented on the Y- or ordinate axis). An analysis is performed with the impedance value (X, Y) as to whether the fault is inside or outside the characteristic. The characteristic it uses is a 4-sided polygon that delimits the characteristic in both X and Y. In other words, the characteristic is delimited by the inductive range and the resistive range, as illustrated in Figure 5. In Figure 5 the characteristic has been defined by a dotted outline. If the operating point obtained with the value of the fault resistance (X-axis) and the fault reactance (Y-axis) is within the characteristic (i.e., the four-sided polygon), the fault is considered to be within the area of action of the quadrilateral distance function (i.e. the fault is within the set range). If the operating point is outside the range, the fault is considered to be outside the area of operation of the function (i.e. the fault is outside the set range). This is the case of the fault in which point $P_{fault} = (R_{fault}, X_{fault})$, as shown in Figure 5. The shown vector $Z_R$ has two components: on the Y-axis it has the set reactance and on the X-axis the resistance of the line from the measurement point to the reactive range. $R_F$ indicates the set resistive range. $X_{fault}$ is the reactance calculated by the function. $R_{fault}$ is the resistance calculated by the function.

For each protected line, the settings (inductive and resistive) have a different value. Depending on whether the operating point is inside or outside the characteristic, the distance unit will or will not send an opening order to switches that isolate the fault and protect the line. It should be noted that a fault generates high currents that can burn or break the line due to the dynamic forces generated, so when a fault is detected, the fault must be isolated as soon as possible. Furthermore, a short circuit in the line can destabilise the network (voltage drops, frequency drops or spikes, etc.). As such, the function (and, therefore, the equipment in which it is integrated) also protects the rest of the network when it isolates the faulty line. If the operating point is outside this characteristic, the distance unit does not send an opening signal to the switches. Furthermore, if the operating point is within this characteristic, the distance unit sends an opening order to the switches.

The inductive range is typically set to 70-90% of the line reactance. This percentage represents the amount of protection provided to the protected line. The resistive range is normally set to no more than 4 times the inductive range. The user is the one who sets these values according to the impedance of the line they want to protect. Since the impedance of the line to the fault is proportional to the fault distance, we can say that we protect, for example, 70% of the line in kilometres or in ohms. That is to say, the reactive range represents a percentage of the line to be protected in ohms.

To correctly determine the reactance from the measurement point to the fault point in the case of resistive faults, reverse sequence current or the homopolar sequence current is usually used as the polarisation current. The reactance X up to the fault point is calculated as follows:

$$X = \text{Im}(\mathbf{Z_{L1}}) \cdot \frac{\text{Im}[\mathbf{V}_{pol} \cdot (\mathbf{I}_{pol})^*]}{\text{Im}[\mathbf{Z_{L1}} \cdot \mathbf{V}_{pol} \cdot \mathbf{I}_{eq} \cdot (\mathbf{I}_{pol})^*]}$$

where $\mathbf{Z_{L1}}$ is the direct sequence impedance of the protected line, $\mathbf{V}_{pol}$ is the polarisation voltage, $\mathbf{I}_{pol}$ is the polarisation

current and $I_{eq}$ is the equivalent current, which, in the case of single-phase faults, corresponds to the compensated current.

To calculate the resistance from the measurement point to the fault point, the real part of the division between the polarisation voltage and the equivalent current is usually taken as the value:

$$R = \text{Re}\left(\frac{V_{pol}}{I_{eq}}\right)$$

The decision rule for determining whether the fault is inside or outside the range is:

- If $X < X_R$ and $R < R_R$ the fault has occurred within the range of the distance unit.
- In the other cases, the fault has occurred outside the range of the unit.

These distance units are very precise in the case of radial systems in which the line is protected from the generation side, even when the faults are resistive faults. In the case of distributed generation, given that the fault current is powered from both ends of the line, the protection begins to lose precision in the case of heterogeneous systems and faults with resistance. A solution to avoid overshooting is to use an adjustable tilt angle for the reactance calculation:

$$X = \text{Im}(\mathbf{Z_{L1}}) \cdot \frac{\text{Im}\left[V_{pol} \cdot \left(I_{pol} \cdot 1\angle\mathbf{Z}_{\text{tilt}}°\right)^*\right]}{\text{Im}\left[\mathbf{Z_{L1}} \cdot V_{pol} \cdot I_{eq} \cdot \left(I_{pol} \cdot 1\angle\mathbf{Z}_{\text{tilt}}°\right)^*\right]}$$

where $\mathbf{Z}_{\text{tilt}}$ is the tilt angle, in degrees, and is adjusted with the value of the difference between the reverse sequence or homopolar sequence angles of current between the two ends of the line at the range value of the line. To do so, it is necessary to know the source impedance of the remote end.

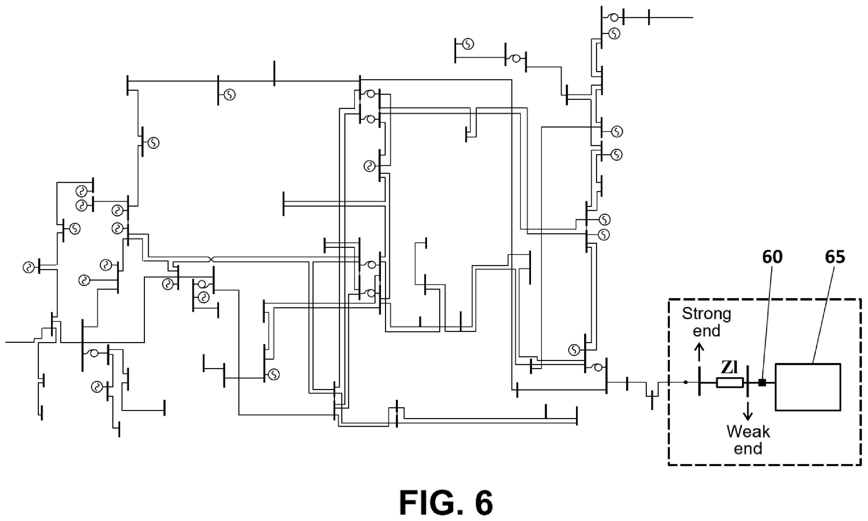

This method has several drawbacks. The first one is that the remote source impedance changes due to the change in topology the system undergoes to optimise the load flow, and as such the adjustment of the source impedance does not represent reality at all times. The second drawback is that, even if the value of the remote source impedance is exactly known, the distance calculation will only be precise when the fault occurs just within the set range (i.e., within the set limit). With out-of-range or in-range faults, the distance calculation is not precise. The weaker the end from which the line is protected, the less precision there is in the distance calculation in heterogeneous networks and in faults with non-zero resistance. This occurs because when there are two ends that feed the fault, each end only measures the contribution thereof. The weaker the end from which the line is protected, the lower the current it provides to the fault. The error becomes greater as the heterogeneity of the network increases and in faults with non-zero resistance. As an example, Figure 6 shows a diagram of a power network in which, shown at the lower right-hand corner, the place 60 where the distance to the fault is measured is identified by a point. This point 60 is the point at which the intensities and voltage are measured, for example, by means of a relay. $Z_l$ represents the impedance of the line to be protected. To the left there is the strong end of the net. To the right of the point 60 there can be a load (it is a passive element of the grid) or there may be a weak source (such as renewable sources, generators with low generating capacity, etc.), represented by 65.

Furthermore, for two-phase faults there is another way to calculate the distance to the fault, which requires determining the value of the remote source impedance in order to accurately calculate the distance (Chenxu Chao et. al., Adaptive distance protection based on the analytical model of additional impedance for inverter-interfaced renewable power plants during asymmetrical faults, 5 October 2022). This method first calculates the seen impedance by dividing the composite voltage by the composite current:

$$Z_{AB} = \frac{V_A - V_B}{I_A - I_B}$$

where $Z_{AB}$ is the seen impedance, $V_A$ is the phase A voltage at the measurement point, $V_B$ is the phase B voltage at the measurement point, $I_A$ is the phase A current at the measurement point and $I_B$ is the phase B current at the measurement point.

This seen impedance $Z_{AB}$ is represented as a function of the fault resistance ($R_F$), direct sequence current ($I_{c1}$), distance to fault in values per unit ($p$), direct sequence impedance of the line ($Z_{L1}$) and measured composite current ($I_A - I_B$).

$$Z_{AB} = \frac{V_A - V_B}{I_A - I_B} = p \cdot Z_{L1} + R_F \cdot \frac{\sqrt{3} \cdot I_{c1} \angle - 90°}{I_A - I_B}$$

In the previous equation, the second addend represents the error that is made by the fault resistance in the distance calculation when the seen impedance is calculated. This error is called additional impedance $Z_{add}$:

$$Z_{add} = R_F \cdot \frac{\sqrt{3} \cdot I_{c1} \angle - 90°}{I_A - I_B}$$

To calculate the distance to the fault, on the one hand, the angle $\varphi_{add}$ of the additional impedance $Z_{add}$ is calculated using trigonometry, putting it as a function of the distance to the fault:

$$\tan \varphi_{add} = \frac{X(p)}{Y(p)}$$

$$X(p) = |Z_{AB}| \cdot \sin \varphi_{AB} - p \cdot |Z_{L1}| \cdot \sin \varphi_L$$

$$Y(p) = |Z_{AB}| \cdot \cos \varphi_{AB} - p \cdot |Z_{L1}| \cdot \cos \varphi_L$$

where $\varphi_L$ is the angle of the impedance of the line to be protected.

On the other hand, this angle $\varphi_{add}$ is calculated by the additional impedance $Z_{add}$. To do so, the fault current is represented as a function of the reverse sequence voltage of phase c at the measurement point ($V_{C2}$), distance to fault (p), direct sequence impedance of the protected line ($Z_{L1}$), direct sequence impedance of the remote source ($Z_{S1}$) and measured composite current ($I_A - I_B$).

$$\varphi_{add} = \arg \frac{\sqrt{3} \angle - 90° \cdot V_{C2}}{[Z_{S1} + (1 - p) \cdot Z_{L1}] \cdot (I_A - I_B)}$$

The direct sequence impedance of the remote source is calculated with the prefault voltage and current variations:

$$Z_{S1} = \frac{\Delta V}{\Delta I} - Z_{L1}$$

By equating the two equations, the only unknown that exists is the distance to the fault. The resulting equation is a second-order equation:

$$\frac{|Z_{AB}| \cdot \sin \varphi_{AB} - p \cdot |Z_{L1}| \cdot \sin \varphi_L}{|Z_{AB}| \cdot \cos \varphi_{AB} - p \cdot |Z_{L1}| \cdot \cos \varphi_L} = -\cot(\arg \frac{\sqrt{3} \angle - 90° \cdot V_{C2}}{[Z_{S1} + (1 - p) \cdot Z_{L1}] \cdot (I_A - I_B)})$$

$$p = \frac{-b \pm \sqrt{b^2 - 4ac}}{2a}$$

$$a = |Z_{L1}|^2 \cdot \cos(2 \cdot \varphi_L - M)$$

$$b = -|Z_{L1}| \cdot |Z_{AB}| \cdot \cos(M - \varphi_{AB} - \varphi_L) - |Z_{L1}| \cdot |Z_S| \cdot \cos(M - \varphi_S - \varphi_L) - |Z_{L1}|^2 \cdot \cos(M - 2 \cdot \varphi_L)$$

$$c = |\mathbf{Z_{S1}}| \cdot |\mathbf{Z_{AB}}| \cdot \cos(\varphi_S + \varphi_{AB} - M) + |\mathbf{Z_{L1}}| \cdot |\mathbf{Z_{AB}}| \cdot \cos(\varphi_L + \varphi_{AB} - M)$$

$$M = \arg \frac{\mathbf{V_{C2}}}{(\mathbf{I_A} - \mathbf{I_B})}$$

This method gives an accurate result for cases where there is no reverse current injection. In the case of reverse current injection, the protection makes a mistake in estimating the distance to the fault. For cases in which there is reverse current injection, a correction angle is used that is calculated with the set maximum range value.

$$\varphi_{corr} = \arg \left\{ 1 - \frac{\mathbf{I_{C2}}}{\mathbf{V_{C2}}} [\mathbf{Z_{S1}} + (1 - \mathrm{p}) \cdot \mathbf{Z_{L1}}] \right\}$$

where $\mathbf{I_{C2}}$ is the reverse sequence current of phase c at the measurement point and $\mathbf{V_{C2}}$ is the reverse sequence voltage of phase c at the measurement point.

This correction angle $\varphi_{corr}$ is applied to the reverse voltage. Therefore, the angle of the additional impedance will be equal to:

$$\varphi_{add} = \arg \frac{\sqrt{3} \angle - 90° \cdot \mathbf{V_{C2}} \angle \varphi_{corr}}{[\mathbf{Z_{S1}} + (1 - \mathrm{p}) \cdot \mathbf{Z_{L1}}] \cdot (\mathbf{I_A} - \mathbf{I_B})}$$

However, even if the angle is corrected, the calculation will only be accurate for faults that occur directly in the range. For faults closer to or further away from range, the distance calculation will not be accurate.

In short, the most advanced distance units currently used are the distance units that use tilt angles, which represent a small improvement over traditional units polarised by reverse sequence and homopolar sequence current.

Even so, these units are not capable of providing a proper response when the line is protected from the weak end of the line, in which case the greater the fault resistance, the worse the response.

Therefore, there is a need to develop new techniques for calculating the distance to a fault and distance units that implement these techniques, which overcome the drawbacks of the techniques and distance units currently known and used.

## DESCRIPTION OF THE INVENTION

The present invention provides a method and a distance unit that aim to solve the drawbacks of the techniques described in the state of the art. Specifically, in order to improve the calculation of the distance to a fault in the case of protecting the line from the weak end in an electric power system, a distance unit is provided which calculates the distance to the fault taking into account more network parameters (than those taken into account in conventional distance units). The distance unit and method implemented in the same are valid to protect the line from the weak end, regardless of whether or not there is reverse current injection. The distance to the fault is therefore calculated more precisely.

The new distance unit, which is a quadrilateral distance unit, represents a new distance unit paradigm that uses a new formulation to accurately determine the distance to the fault for cases in which a line is protected from the weak end in an alternating current (AC) electric power system. This new formulation takes all the parameters of the network into account, and therefore it is able to surpass all existing units to date. Specifically, the distance is calculated using the direct sequence impedance, which appears in all types of faults (single-phase, two-phase, two-phase to ground and three-phase). It must be noted that homopolar impedance does not appear in two-phase faults. Neither homopolar impedance nor reverse impedance appears in three-phase faults.

Given that the design thereof is adapted to weak ends, it is suitable for use at the ends of the output lines of, for example, inverter-based generation plants. Inverter-based generators can have the option of injecting only direct sequence current, or both direct sequence and reverse sequence current when a fault occurs. The new algorithm performs precise calculations in both cases.

The proposed distance unit comprises a module for calculating distance (which, for example, for each type and fault phases, calculates the distance to the fault). The algorithm proposed in the present invention is preferably embedded in said distance calculating module. Thus, the new distance unit accurately determines the distance to the fault for cases in which the line is protected from the weak end.

The weaker the end from which the line is protected, the less precision there is in the distance calculation in heterogeneous networks and in faults with non-zero resistance. This occurs because when there are two ends that feed the fault, each end only measures the contribution thereof.

In the context of the present invention, an end from which a line is protected is called a "weak end" when it is the end that contributes less fault current than the other end. Thus, the other end from which the line is protected is called the "strong end", since it is the end that provides the most fault current. The distance unit is located at one of the ends or points of the line being protected. Of these two ends, the end that provides much less fault current than the other end is the weak end. The other end is the strong end. In other words, the weak end has a much lower short-circuit power than the strong end. The weak end can be weak due to the fact that it does not have a generation power that is as high as the strong end.

The distance unit may comprise other modules, typically present in conventional distance units, such as a fault detector (which indicates when a fault has occurred and whether it is a single-phase, two-phase, two-phase-to-ground or three-phase fault), a fault selector (which indicates which phases are involved in the fault) and/or a directional indicator (which indicates whether the fault is in front of or behind the measurement point).

The proposed distance calculation is based on the observation by the inventors that in the case of protecting the line from the weak end, the distance to the fault can be accurately calculated in the case of single-phase, two-phase and three-phase faults, regardless of whether or not there is fault resistance. Thus, the inventors have developed an algorithm that is valid for weak ends regardless of whether there is reverse sequence current injection in the case of fault detection.

The calculation of the distance to the fault is preferably carried out in the protection system itself, meaning locally in the distance unit itself, for example. The distance calculation can be sent, in real time or not, to a control centre, which is usually remote. Alternatively, the distance calculation can be carried out remotely, from measurements taken by other equipment, such as sensors arranged at different points of the power network.

The distance unit determines the impedance at which a fault has occurred by dividing the voltage and current on the protected line when a fault occurs. As explained in the state of the art, the distance function has a characteristic that is defined by the inductive range and the resistive range. For each line, these settings have a different value. The adjustment of the ranges falls outside the present invention.

Once the distance to the fault is calculated, it is compared to preset values (preset characteristic) to determine if the fault is inside or outside the protected line.

The proposed distance unit is implemented in a protection system. Once it is established whether the fault is inside or outside the protected line, a decision can be made to act (isolate the fault, etc.) in the case that the same is inside the protected line.

Depending on whether the operating point (the point where the fault is estimated to be with a specific fault resistance) is inside or outside this characteristic (the estimated range), the distance unit (or, in general, the protection system) will send or will not send an opening order to switches to isolate the fault. If the operating point is outside this characteristic, the opening order will not be sent to the switches. However, if the operating point is within this characteristic, an opening order will be sent to the switches.

Normally, an attempt is made to protect a certain percentage of the line. For example, at least 70% of the line is protected, such as at least 80% or at least 90% of the line. It must be mentioned that since the distance is proportional to the line impedance, a certain percentage of the line corresponds to that same percentage of the line impedance.

In general, when a fault occurs (for example, a short circuit), the proposed calculation method uses the direct, reverse and homopolar sequence voltage and the direct, reverse and homopolar sequence current that circulates through the point at which the fault unit is located. It must be noted that when reference is made to voltages and/or currents used, it must be understood that said voltages and/or currents have been measured or calculated. The distance to the fault is calculated based on the homopolar, direct and reverse sequence voltages $V_0$, $V_1$, $V_2$, homopolar, direct and reverse sequence currents $I_0$, $I_1$, $I_2$ and homopolar and direct sequence impedances $Z_{L0}$, $Z_{L1}$ and reactive and resistive range set values $X_R$, $R_R$ set by the user. It must be noted that $Z_{L1}$ (direct sequence impedance of the protected line) = $Z_{L2}$ (reverse sequence impedance of the protected line). The reactive range set value $X_R$ is preferably set to a value comprised between 70-90% of the reactance of the protected line. The resistive range set value $R_R$ is preferably set to at most 4 times the reactive range.

A first aspect of the invention provides a computer-implemented method (or digitally implemented method) for determining a distance at which a fault occurs in a protected power line of an electric power system, wherein the power line is protected from a weak end of the power line, comprising: measuring the following magnitudes at a measurement point of the protected line from a weak end where the fault occurs: the phase A current at the measurement point ($I_a$), phase B current at the measurement point ($I_b$), phase C current at the measurement point ($I_c$), phase A voltage at the measurement point ($V_a$), phase B voltage at the measurement point ($V_b$) and phase C voltage at the measurement point ($V_c$); based on the previous measurements, calculating the following magnitudes of the power line: homopolar sequence voltage at the measurement point ($V_0$), direct sequence voltage at the measurement point ($V_1$), reverse sequence voltage at the measurement point ($V_2$), homopolar sequence current at the measurement point ($I_0$), direct sequence current at the measurement point ($I_1$), reverse sequence current at the measurement point ($I_2$), equivalent voltage ($V_{eq}$), equivalent current ($I_{eq}$) and polarisation voltage ($V_{pol}$); calculating the distance p at which a single-phase, two-phase or three-phase fault occurs in the protected power line based on the following formula:

$$\text{Im}\left[\left(\boldsymbol{V_{pol}}\right)^* \cdot \mathbf{Z_{L1}}^2 \cdot \boldsymbol{I_{eq}}\right] \cdot p^2 + \text{Im}\left\{-\left(\boldsymbol{V_{pol}}\right)^* \cdot \mathbf{Z_{L1}} \cdot \left[\boldsymbol{V_{eq}} + \boldsymbol{I_{eq}} \cdot (\mathbf{Z_{S1}} + \mathbf{Z_{L1}})\right]\right\} \cdot p$$
$$+ \text{Im}\left[\left(\boldsymbol{V_{pol}}\right)^* \cdot \boldsymbol{V_{eq}} \cdot (\mathbf{Z_{S1}} + \mathbf{Z_{L1}})\right] = 0$$

where $\mathbf{Z_{L1}}$ is the direct sequence impedance of the protected line and is known; and $\mathbf{Z_{S1}}$ is the direct sequence impedance of the remote source and has been calculated before the fault occurs based on measurements of direct sequence voltage at the measurement point $V_1$ and direct sequence current at measurement point $I_1$ at two different moments in a no-fault situation;

where the value of the distance to the fault is the minimum solution of the following two possible solutions:

$$p = \min\left(\frac{-b + \sqrt{b^2 - 4ac}}{2a}, \frac{-b - \sqrt{b^2 - 4ac}}{2a}\right)$$

where

$$a = \text{Im}\left[\left(\boldsymbol{V_{pol}}\right)^* \mathbf{Z_{L1}}^2 \cdot \boldsymbol{I_{eq}}\right]$$

$$b = \text{Im}\left\{-\left(\boldsymbol{V_{pol}}\right)^* \cdot \mathbf{Z_{L1}} \cdot \left[\boldsymbol{V_{eq}} + \boldsymbol{I_{eq}} \cdot (\mathbf{Z_{S1}} + \mathbf{Z_{L1}})\right]\right\}$$

$$c = \text{Im}\left[\left(\boldsymbol{V_{pol}}\right)^* \cdot \boldsymbol{V_{eq}} \cdot (\mathbf{Z_{S1}} + \mathbf{Z_{L1}})\right]$$

In embodiments of the invention, the method further comprises calculating, based on the distance to the fault $p$, the reactance to the fault point from the measurement point:

$$X = p \cdot \mathbf{X_{L1}}$$

where $X_{L1}$ is the direct sequence reactance of the protected line.
In embodiments of the invention the method further comprises calculating, based on the distance to the fault $p$, the fault resistance:

$$\mathbf{R_F} = \mathbf{R} = \frac{\boldsymbol{V_{eq}} \cdot (\mathbf{Z_{S1}} + \mathbf{Z_{L1}}) + p \cdot \mathbf{Z_{L1}} \cdot \left[-\boldsymbol{V_{eq}} - \boldsymbol{I_{eq}} \cdot (\mathbf{Z_{S1}} + \mathbf{Z_{L1}})\right] + p^2 \cdot (\mathbf{Z_{L1}})^2 \cdot \boldsymbol{I_{eq}}}{\boldsymbol{V_{pol}}}$$

where R is the resistance seen from the measurement point to the fault point.
In embodiments of the invention the method further comprises: comparing the reactance to the fault point from the measurement point $X$ to a reactive range set value $X_R$ previously chosen; comparing the resistance seen from the measurement point to the fault point R to a resistive range set value $R_R$ previously chosen; and

- if $X < X_R$ and $R < R_R$:

  determining that the fault has occurred within the range of one distance unit;
  optionally, activating a switch to isolate the fault from the rest of the electric power system.

In embodiments of the invention, if the fault is single-phase:

- if the fault occurs in phase A, the values of polarisation voltage $\boldsymbol{V_{pol}}$, equivalent voltage $\boldsymbol{V_{eq}}$ and equivalent current $\boldsymbol{I_{eq}}$,

$$\boldsymbol{V_{pol}} = 3 \cdot \left[-\boldsymbol{V_2} + \boldsymbol{I_2} \cdot (\mathbf{Z_{S1}} + \mathbf{Z_{L1}})\right]$$

$$\boldsymbol{V_{eq}} = \boldsymbol{V_a}$$

$$I_{eq} = I_a + I_N \cdot K_N$$

where: $I_N$ is the neutral current at the measurement point, which is $I_N = 3 \cdot I_0$ and **KN** is the homopolar sequence compensation factor, $\mathrm{K_N} = \dfrac{\mathrm{Z_{L0}} - \mathrm{Z_{L1}}}{3 \cdot \mathrm{Z_{L1}}}$

- if the fault occurs in phase B, the values of polarisation voltage $V_{pol}$, equivalent voltage $V_{eq}$ and equivalent current $I_{eq}$,

$$V_{pol} = 3 \cdot \mathrm{a} \cdot [-V_2 + I_2 \cdot (\mathrm{Z_{S1}} + \mathrm{Z_{L1}})]$$

$$V_{eq} = V_b$$

$$I_{eq} = I_b + I_N \cdot K_N$$

where: a is equal to $1 \angle 120°$, and is known in advance, $I_N$ is the neutral current at the measurement point, which is $I_N = I_0$ and $K_N$ is the homopolar sequence compensation factor, $\mathrm{K_N} = \dfrac{\mathrm{Z_{L0}} - \mathrm{Z_{L1}}}{3 \cdot \mathrm{Z_{L1}}}$

- if the fault occurs in phase C, the values of polarisation voltage $V_{pol}$, equivalent voltage $V_{eq}$ and equivalent current $I_{eq}$,

$$V_{pol} = 3 \cdot \mathrm{a}^2 \cdot [-V_2 + I_2 \cdot (\mathrm{Z_{S1}} + \mathrm{Z_{L1}})]$$

$$V_{eq} = V_c$$

$$I_{eq} = I_c + I_N \cdot K_N$$

where: a is equal to $1 \angle 120°$, and is known in advance, $I_N$ is the neutral current at the measurement point, $I_N = 3 \cdot I_0$ and $K_N$ is the homopolar sequence compensation factor, $\mathrm{K_N} = \dfrac{\mathrm{Z_{L0}} - \mathrm{Z_{L1}}}{3 \cdot \mathrm{Z_{L1}}}$ .

In embodiments of the invention, if the fault is two-phase:

- if the fault occurs in the phases BC, the values of polarisation voltage $V_{pol}$, equivalent voltage $V_{eq}$ and equivalent current $I_{eq}$,

$$V_{pol} = -2 \cdot [-V_2 + I_2 \cdot (\mathrm{Z_{S1}} + \mathrm{Z_{L1}})]$$

$$V_{eq} = V_1 - V_2 = \mathrm{j}\frac{\sqrt{3}}{3} \cdot (V_b - V_c)$$

$$I_{eq} = I_1 - I_2 = \mathrm{j}\frac{\sqrt{3}}{3} \cdot (I_b - I_c)$$

- if the fault occurs in the phases CA, the values of polarisation voltage $V_{pol}$, equivalent voltage $V_{eq}$ and equivalent current $I_{eq}$,

$$V_{pol} = -\mathrm{a} \cdot 2 \cdot [-V_2 + I_2 \cdot (\mathrm{Z_{S1}} + \mathrm{Z_{L1}})]$$

$$V_{eq} = \mathrm{a}^2 \cdot V_1 - \mathrm{a} \cdot V_2 = \mathrm{j}\frac{\sqrt{3}}{3} \cdot (V_c - V_a)$$

$$I_{eq} = \mathbf{a}^2 \cdot I_1 - \mathbf{a} \cdot I_2 = j\frac{\sqrt{3}}{3} \cdot (I_c - I_a)$$

where: a is equal to $1\angle 120°$, and is known in advance,

- if the fault occurs in the phases BA, the values of polarisation voltage $V_{pol}$, equivalent voltage $V_{eq}$ and equivalent current $I_{eq}$,

$$V_{pol} = -\mathbf{a}^2 \cdot 2 \cdot [-V_2 + I_2 \cdot (Z_{S1} + Z_{L1})]$$

$$V_{eq} = \mathbf{a} \cdot V_1 - \mathbf{a}^2 \cdot V_2 = j\frac{\sqrt{3}}{3} \cdot (V_a - V_b)$$

$$I_{eq} = \mathbf{a} \cdot I_1 - \mathbf{a}^2 \cdot I_2 = j\frac{\sqrt{3}}{3} \cdot (I_a - I_b)$$

$$V_{eq} = V_1$$

where: a is equal to $1\angle 120°$, and is known in advance.

In embodiments of the invention, if the fault is three-phase, the values of polarisation voltage $V_{pol}$, $V_{eq}$ and equivalent current $I_{eq}$, obtained as follows:

$$V_{pol} = [-V_{1pure} + I_{1pure} \cdot (Z_{S1} + Z_{L1})]$$
$$V_{eq} = V_1$$

$$I_{eq} = I_1$$

where $V_{1pure}$ is the direct sequence fault voltage at the measurement point where the prefault value has been eliminated, $I_{1pure}$ is the direct sequence fault current at the measurement point where the prefault value has been eliminated.

A second aspect of the invention provides a distance unit for determining the distance at which a fault occurs on a protected power line of an electric power system, wherein the power line is protected from a weak end of the power line, comprising: means for measuring the following magnitudes at a measurement point of the protected line from a weak end where the fault occurs: the phase A current at the measurement point ($I_a$), phase B current at the measurement point ($I_b$), phase C current at the measurement point ($I_c$), phase A voltage at the measurement point ($V_a$), phase B voltage at the measurement point ($V_b$) and phase C voltage at the measurement point ($V_c$); means for, based on the previous measurements, calculating the following magnitudes of the power line: homopolar sequence voltage at the measurement point ($V_0$), direct sequence voltage at the measurement point ($V_1$), reverse sequence voltage at the measurement point ($V_2$), homopolar sequence current at the measurement point ($I_0$), direct sequence current at the measurement point ($I_1$), reverse sequence current at the measurement point ($I_2$), equivalent voltage ($V_{eq}$), equivalent current ($I_{eq}$) and polarisation voltage ($V_{pol}$); means for calculating the distance $p$ at which a single-phase, two-phase or three-phase fault occurs in the protected power line based on the formula defined in the first aspect of the present invention, and wherein the value of the distance to the fault is the minimum solution of the two possible solutions defined in the first aspect of the invention.

In embodiments of the invention, the distance unit further comprises means for calculating the reactance to the fault point from the measurement point based on the distance to the fault $p$:

$$X = p \cdot X_{L1}$$

where $X_{L1}$ is the direct sequence reactance of the protected line.

In embodiments of the invention, the distance unit further comprises means for calculating the fault resistance, based on the distance to the fault $p$, according to the expression defined in the first aspect of the invention.

In embodiments of the invention, the distance unit further comprises: means for comparing the reactance to the fault point from the measurement point $X$ with a previously established reactive range set value $X_R$; means for comparing the resistance seen from the measurement point to the fault point R with a previously established resistive range set value

$R_R$; and means for, if $X < X_R$ and $R < R_R$: determining that the fault has occurred within the range of a distance unit; optionally, actuating a switch to isolate the fault from the rest of the electric power system.

In embodiments of the invention, the distance unit provides specific calculations based on whether the fault is single-phase, two-phase or three-phase, in a similar way to the method of the first aspect of the invention.

A third aspect of the invention provides a protection system for an electric power system comprising a distance unit according to the second aspect of the invention.

Given that the proposed calculation algorithm for distance to the fault takes into account the aforementioned network parameters, it is able to overcome the drawbacks of conventional distance units. Since the design thereof is adapted to weak ends, it is suitable to be used, for example, at the ends of the output lines of inverter-based generation plants or at any other type of weak end of a power network, such as an end with high impedance or with little capacity to generate fault current. In the case of inverter-based generators, these generators can have the option of injecting only direct sequence current or both direct sequence and reverse sequence current when a fault occurs. The proposed algorithm calculates the distance to the fault accurately in both cases.

The proposed distance unit has the following improved characteristics over existing units: It indicates the correct fault distance from the weak end of the line. It is valid for cases of reverse sequence injection. It accurately calculates single-phase, two-phase and three-phase faults. It is not affected by fault resistance. It accurately calculates remote source impedance.

These and other advantages and features of the invention will become apparent in light of the figures and the detailed description of the invention.

## BRIEF DESCRIPTION OF DRAWINGS

To complement the description and for the purpose of making the features of the invention more readily understandable according to a practical exemplary embodiment thereof, a set of figures is attached as an integral part of the description in which the following has been depicted with an illustrative and nonlimiting character:

Figure 1A schematically shows a three-phase system (phases a, b, c) in which a fault has occurred in phase "a" (single-phase fault). Figure 1B shows a representation of the single-phase fault by means of sequence networks.

Figure 2A schematically shows a three-phase system (phases a, b, c) in which a fault has occurred in two phases: "b" and "c" (two-phase fault). Figure 2B shows a representation of the two-phase fault by means of sequence networks.

Figure 3A schematically shows a three-phase system (phases a, b, c) in which a two-phase ground fault has occurred in phases "b" and "c". Figure 3B shows a representation of the two-phase fault by means of sequence networks.

Figure 4A shows a three-phase system (phases a, b, c) in which a balanced three-phase fault has occurred. Figure 4B shows a representation of the balanced three-phase fault by means of sequence networks.

Figure 5 shows a coordinate diagram representation of the distance at which a fault has occurred. The distance has a resistive dimension (X- or abscissa axis) and an inductive dimension (Y- or ordinate axis).

Figure 6 shows a diagram of a power network in which the distance unit is located at the weak end. The strong end and the weak end of the network are shown with respect to the distance unit.

Figure 7A shows a diagram of a network, in which the strong end and the weak end are identified with respect to the protected line. In this case, the weak end is an end that has a transformer with a grounded star connection on the measurement side without active generation sources on the delta side of the transformer.

Figure 7B shows a diagram of a network, in which the strong end and the weak end are identified with respect to the protected line. In this case, the weak end is an end in which there are renewable sources.

Figure 8 shows a representation or model of a power network. In this model, the network to the left of the strong end is represented by the Thevenin equivalent with a voltage source and a remote source impedance. The network to the right of the weak end is represented as a weak source or load.

Figure 9 shows a diagram of a representation of the modelling of a network without a fault in accordance with a possible embodiment of the invention.

Figure 10 shows a diagram of a representation of the modelling of a network with a fault in accordance with a possible embodiment of the invention.

Figure 11 shows a diagram of a representation of the modelling of a single-phase fault in a network according to a possible embodiment of the invention. The fault has been modelled with three sequence networks.

Figure 12 shows a diagram of a representation of the modelling of a two-phase fault in a network according to a possible embodiment of the invention. The fault has been modelled with two sequence networks.

Figure 13 shows a diagram of a representation of the modelling of a three-phase fault in a network according to a possible embodiment of the invention. The fault has been modelled with a sequence network.

Figure 14 shows a diagram of a representation of the modelling of a sequence network in a prefault situation according to a possible embodiment of the invention. The network is represented by a strong end modelled as a voltage source with a source impedance and a weak end modelled by a current source and source impedance (the weak end can also be modelled by a load, i.e. without a current source). The prefault situation is the correct situation (without a fault) that exists before the fault occurs, but does not give information about whether or not a fault will occur.

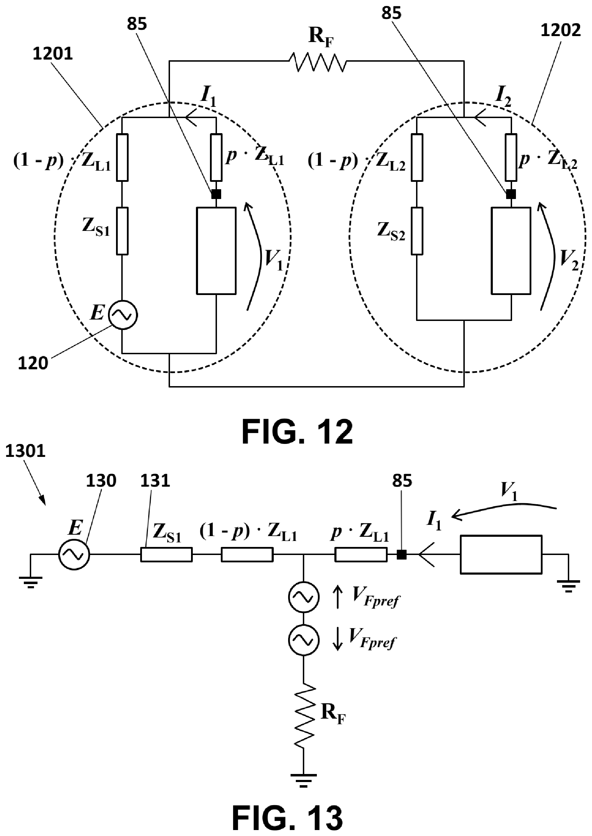

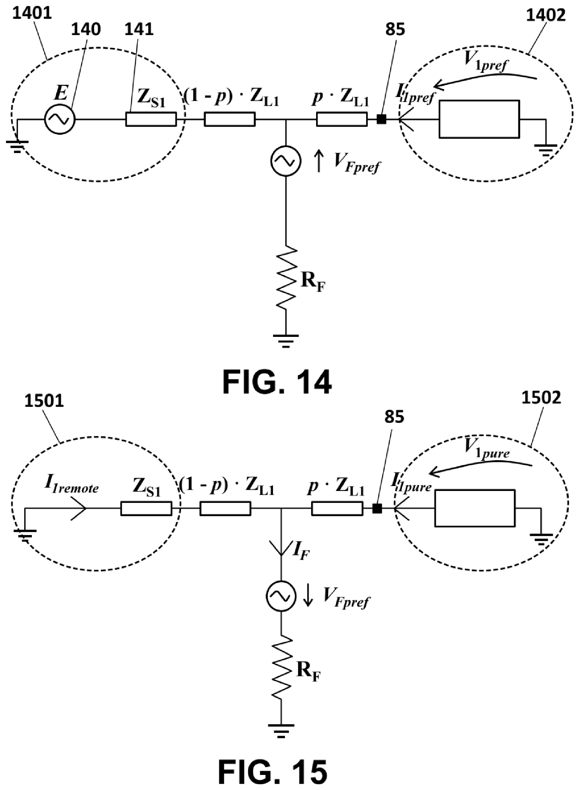

Figure 15 shows a diagram of a representation of the modelling of a pure three-phase fault in a network, according to a possible embodiment of the invention. The fault has been modelled with a sequence network. The network is represented by a strong end modelled as a source impedance and a weak end modelled by a current source and the source impedance thereof (the weak end can also be modelled by a load, i.e. without a current source). It must be noted that the three-phase fault modelled in Figure 13 has the prefault effect, while in the pure three-phase fault modelled in Figure 15 the prefault effect has been eliminated.

## DESCRIPTION OF A MANNER OF CARRYING OUT THE INVENTION

In the general diagram of a power network shown in Figure 6, the distance unit is located at one of the ends of the line being protected, that is, at the point 60, in which the voltage and currents are measured. The distance is calculated with these voltage and current measurements. In Figure 6, the strong end is to the left of the impedance of the protected line $Z_l$ and the weak end is to the right of this impedance. The end that supplies much less fault current than the other end is the weak end. The other end is the strong end.

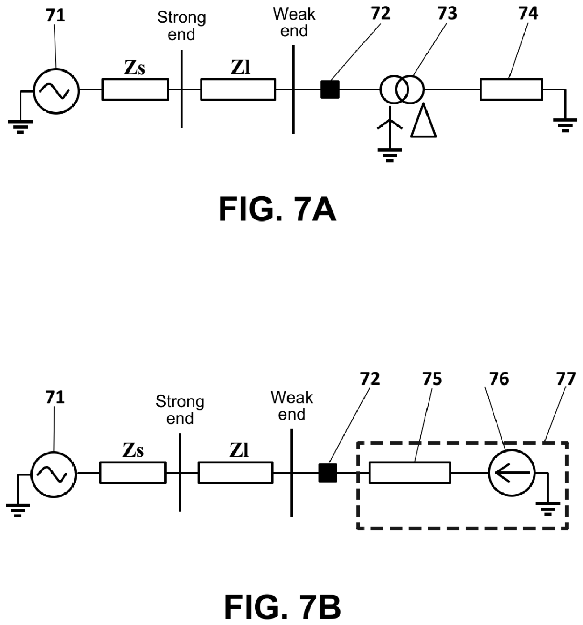

By way of example, a weak end may be an end where there are only loads, with no generating power. For example, Figure 7A represents a diagram of a network (equivalent network), in which the strong end and the weak end are identified with respect to the protected line (represented by the impedance $Z_l$ thereof). The point 72 at which voltages and currents are measured (for example, measured by a relay) is the point at which the distance unit is normally located. To the right of this point 72, that is, at the weak end, there is no generation source. The equivalent network comprises a Thevenin equivalent voltage source 71 at the strong end. To the right of the, for example, relay, there is a grounded star transformer 73 on the measurement side and delta on the other side of the transformer. The load 74 of the weak end does not imply a generation source. Another example of a weak end is the case in which there are renewable sources, which have little generating power, located behind the point 72 at which the relay is placed, as illustrated in Figure 7B. In this case, the weak end is represented by a current source 76 representing a renewable source and the equivalent impedance 75 of the weak end (impedance between the point 72 and the current source 76). The current source along with the equivalent impedance of the weak end is represented by 77.

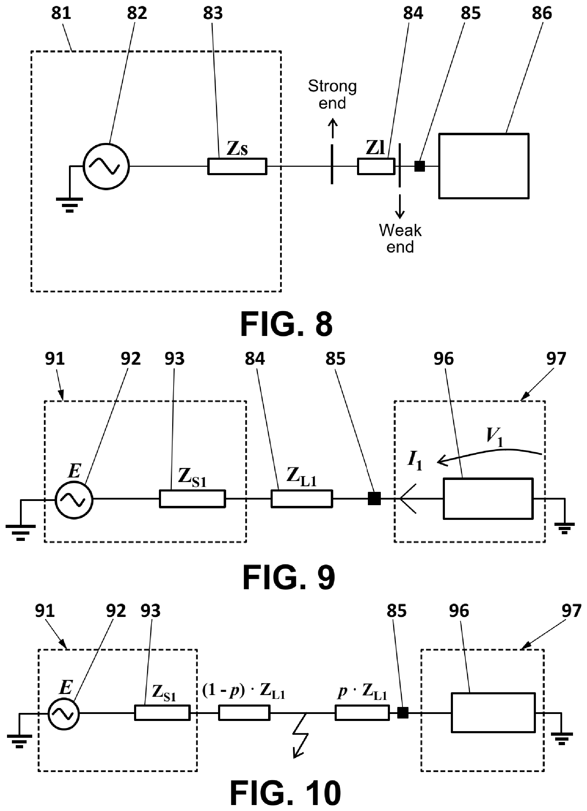

Figure 8 shows a representation or model of a power network, such as the network of Figure 6. The network 81 to the left of the strong end can be represented by the Thevenin equivalent with a voltage source 82 and a remote source impedance $Z_s$ 83, as shown in Figure 8. The dashed box 81 represents the strong end. The line being protected or to be protected is represented by a line impedance $Z_l$. The distance unit is located at one end of the line being protected. In the diagram in figure 8, the distance unit is connected to the relay located at the point 85. This relay takes voltage and current measurements. Of these two ends, the end that provides much less fault current than the other end is the weak end. The other end is the strong end. The weak end is represented by a weak source 86 or load. The weaker the end from which the line is protected, the lower the current it provides to the fault. The error becomes greater as the heterogeneity of the network increases and in faults with non-zero resistance. In perfectly homogeneous networks, the distance calculation would not be affected. The strong end provides a lot of fault current. The weak end has a much lower short-circuit power than the strong end. The weak end can be weak due to the fact that it does not have a generation power that is as high as the strong end, as schematised in Figures 7A and 7B. The current that passes through the fault point is the sum of the currents provided by the two ends. When a fault occurs, the remote source impedance $Z_s$ is normally small, and therefore the current that circulates through the same is high. The weak end provides little current to the fault.

Figure 9 shows a diagram of a representation of the modelling of a network without a fault in accordance with a possible embodiment of the invention. The network is represented by a strong end 91 modelled as a voltage source E 92 with a direct sequence impedance (appearing in all types of faults) from the remote source $Z_{s1}$ 93 and a weak end 97 (which can be a source or load 96) modelled by a current source and the source impedance thereof. **E** is the equivalent Thevenin voltage at the remote end. In Figure 9, $V_1$ is the direct sequence voltage at the measurement point 85 and $I_1$ is the direct sequence current at the measurement point. In the diagram of Figure 9, the measurement unit is connected to the relay 85.

Figure 10 shows a diagram of a representation of the modelling of the network of Figure 9, with a fault. The network is represented by a strong end 91 modelled as a voltage source **E** 92 with a direct sequence impedance from the remote source $Z_{s1}$ 93 and a weak end 97 (which can be a source or load 96) modelled by a current source and the source impedance thereof. The point at which the fault occurs is located at a distance p from the measurement point 85. In the diagram of Figure 10, the measurement unit is connected to the relay 85. The direct sequence impedance of the protected line $Z_{L1}$ is represented in two pieces (1-p) $Z_{L1}$ and p $Z_{L1}$ to represent the fault at distance p.

The proposed algorithm for calculating the distance to the fault needs, as an input, the value of the direct sequence impedance of the remote source $Z_{s1}$. The remote source impedance $Z_s$ is variable, so it is necessary to recalculate this value. For example, in systems with renewable sources and in distribution networks, the injected current is usually variable due to the variation that exists in the load. The value of the remote source impedance can be recalculated when a variation in the current (injected current) is detected. Alternatively, the periodic recalculation of said impedance value is envisioned.

Two voltage and current values are needed to calculate the direct sequence impedance of the remote source $Z_{s1}$. These two different voltage and current values (direct sequence) are measured at the point 85 at different moments in time in a no-fault situation. The first value used preferably corresponds to a moment prior to the detection of a variation in the load current $I_1$ (direct sequence current at the measurement point 85) and the second value preferably corresponds to an instant after the detection of said variation.

Analysing Figure 9, the calculation of remote source direct sequence impedance $Z_{s1}$ is obtained (see for example EP3361272A1 or Chenxu Chao et. al., Adaptive distance protection based on the analytical model of additional impedance for inverter-interfaced renewable power plants during asymmetrical faults, 5 October 2022, which are incorporated into this description by reference):

$$Z_{S1} = \frac{\Delta V}{\Delta I} - \mathbf{Z}_{L1}$$

where $\mathbf{Z_{L1}}$ is the direct sequence impedance of the protected line, $\Delta\mathbf{V}$ is the variation in the direct sequence voltage measured at the point 85 and $\Delta\mathbf{I}$ is the variation in the direct sequence current measured at the point 85.

When a short circuit (generally a fault) occurs somewhere on the protected line from the weak end, the direct, reverse and homopolar sequence voltage and the direct, reverse and homopolar sequence current flowing through the point at which the distance unit (point 85) is located are used. The distance to the fault is then calculated based on the direct, reverse and homopolar sequence voltages $\mathbf{V_0}, \mathbf{V_1}, \mathbf{V_2}$, currents $\mathbf{I_0}, \mathbf{I_1}, \mathbf{I_2}$ and impedances $\mathbf{Z_{L0}}, \mathbf{Z_{L1}}$ (it must be noted that $\mathbf{Z_{L1}} = \mathbf{Z_{L12}}$) and the reactive and resistive range set values $X_R$, $R_R$ set by the user, to determine the range (distance) of the fault. It is noteworthy that the remote source direct sequence impedance $\mathbf{Z_{S1}}$ has been previously calculated using direct voltage and current measurements $\mathbf{V_1}, \mathbf{I_1}$ at two different moments in a no-fault situation. When a variation occurs between these two magnitudes, two $V_1$ values (one of those values is before the variation and the other value is after the variation) and two $I_1$ values (one of those values is before the variation and the other value is after the variation) are obtained.

The distance to fault calculation algorithm for single-phase, two-phase and three-phase faults is described in detail below. In addition, based on said algorithm developed for each of the three types of faults, a general equation is obtained that is valid for any of the three types of faults.

SINGLE -PHASE FAULTS

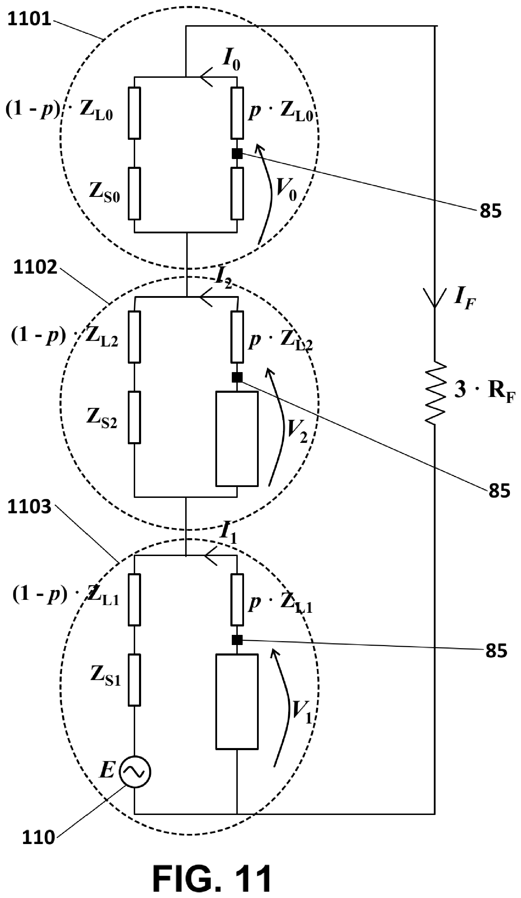

Figure 11 shows a diagram of a representation of the modelling of a single-phase fault in a network according to a possible embodiment of the invention. In accordance with fault theory, the fault has been modelled with three sequence networks 1101, 1102, 1103. The network is represented by a strong end modelled as a voltage source $\mathbf{E}$ 110 with a source impedance $Z_s$ (represented by three impedances of the homopolar sequence remote source $Z_{s0}$, direct sequence $Z_{s1}$ and reverse sequence $Z_{s2}$) and a weak end that can be represented as a source or load. In the diagram of Figure 11, the measurement unit is connected to the relay (point 85). Although physically there is only one fault point, when modelling the same as sequence networks, for each sequence network a fault point is modelled in the diagram, represented by p and (1-p), as well as a measurement point 85. The measurement point 85 collects measurements of $I_a$, $I_b$, $I_c$, $V_a$, $V_b$ and $V_c$. At the measurement point, or alternatively if these measurements are sent to a control system, $I_0, I_1, I_2, V_0, V_1, V_2, I_{eq}, V_{eq}, V_{pol}$ are calculated based on the measurements.

Figure 11 shows: the homopolar sequence impedance of the protected line $\mathbf{Z_{L0}}$; $\mathbf{Z_{L1}}$; sequence impedance of the protected line $\mathbf{Z_{L2}}$; at the measurement point $\mathbf{V_0}$; the direct sequence voltage at the measurement point $\mathbf{V_1}$ (source or load); the reverse sequence voltage at the measurement point $\mathbf{V_2}$ (source or load); $\mathbf{I_0}$ the homopolar sequence current at the measurement point; the direct sequence current at the measurement point $\mathbf{I_1}$; the reverse sequence current at the measurement point $\mathbf{I_2}$; the homopolar sequence impedance of the remote source $\mathbf{Z_{S0}}$; remote source $\mathbf{Z_{S1}}$; $\mathbf{Z_{S2}}$; the fault resistance $R_F$ and the fault current at the fault point $\mathbf{I_F}$.

Based on Figure 11, the equations involved are the following:

$$\mathbf{V_1} - \mathbf{I_1} \cdot p \cdot \mathbf{Z_{L1}} + \mathbf{V_2} - \mathbf{I_2} \cdot p \cdot \mathbf{Z_{L2}} + \mathbf{V_0} - \mathbf{I_0} \cdot p \cdot \mathbf{Z_{L0}} = \mathbf{I_F} \cdot 3 \cdot R_F$$

$$\mathbf{I_F} = \frac{-\mathbf{V_2} + \mathbf{I_2} \cdot (\mathbf{Z_{S2}} + \mathbf{Z_{L2}})}{(1-p) \cdot \mathbf{Z_{L2}} + \mathbf{Z_{S2}}}$$

$$Z_{S1} = Z_{S2}$$

$$Z_{L1} = Z_{L2}$$

By solving the four equations, we arrive at the following second-order equation where the unknowns are the distance to the fault (p) and the fault resistance ($R_F$):

$$V_a \cdot (Z_{S1} + Z_{L1}) + p \cdot Z_{L1} \cdot [-V_a - (I_a + I_N \cdot K_N) \cdot (Z_{S1} + Z_{L1})] + p^2 \cdot Z_{L1}{}^2$$
$$\cdot (I_a + I_N \cdot K_N) = [-V_2 + I_2 \cdot (Z_{S1} + Z_{L1})] \cdot 3 \cdot R_F$$

where:

$V_a$ is the phase A voltage (in which the single-phase fault is assumed to have occurred); this voltage Va is equal to the sum of the homopolar sequence voltage at the measurement point ($V_0$), the direct sequence voltage at the measurement point ($V_1$) and the reverse sequence voltage at the measurement point ($V_2$):

$$V_a = V_0 + V_1 + V_2$$

$I_a$ is the phase A current which is equal to the sum of the homopolar sequence current at the measurement point ($I_0$), the direct sequence current at the measurement point ($I_1$) and the reverse sequence current at the measurement point ($I_2$):

$$I_a = I_0 + I_1 + I_2$$

$I_N$ is the neutral current at the measurement point, which is equal to three times the homopolar current:

$$I_N = 3 \cdot I_0$$

$K_N$ is the compensation factor of the homopolar sequence that is calculated from $Z_{L1}$ and $Z_{L0}$:

$$K_N = \frac{Z_{L0} - Z_{L1}}{3 \cdot Z_{L1}}$$

If we polarise with the following voltage $V_{pol}$, the fault resistance will be eliminated (in other words, the effect of the fault resistance will be eliminated), so the only unknown in the equation will be the distance to the fault (note that choosing the polarisation voltage ad hoc to eliminate the effect of fault resistance is common in conventional fault distance calculation methods):

$$3 \cdot [-V_2 + I_2 \cdot (Z_{S1} + Z_{L1})]$$

Polarising by means of this voltage (the voltage that is used to eliminate the fault resistance from the equation) and taking the imaginary part, the previous equation will be the following:

$$\mathrm{Im}\{[-V_2 + I_2 \cdot (Z_{S1} + Z_{L1})]^* V_a \cdot (Z_{S1} + Z_{L1})\} + p$$
$$\cdot \mathrm{Im}\{[-V_2 + I_2 \cdot (Z_{S1} + Z_{L1})]^* \cdot Z_{L1}$$
$$\cdot [-V_a - (I_a + I_N \cdot K_N) \cdot (Z_{S1} + Z_{L1})]\} + p^2$$
$$\cdot \mathrm{Im}\{[-V_2 + I_2 \times (Z_{S1} + Z_{L1})]^* \cdot Z_{L1}{}^2 \cdot (I_a + I_N \cdot K_N)\} = 0$$

It is a second-order equation:

$$a \cdot p^2 + b \cdot p + c = 0$$

where:

$$a = \text{Im}\{[-V_2 + I_2 \cdot (Z_{S1} + Z_{L1})]^* \cdot Z_{L1}{}^2 \cdot (I_a + I_N \cdot K_N)\}$$

$$b = \text{Im}\{[-V_2 + I_2 \cdot (Z_{S1} + Z_{L1})]^* \cdot Z_{L1} \cdot [-V_a - (I_a + I_N \cdot K_N) \cdot (Z_{S1} + Z_{L1})]\}$$

$$c = \text{Im}\{[-V_2 + I_2 \cdot (Z_{S1} + Z_{L1})]^* \cdot V_a \cdot (Z_{S1} + Z_{L1})\}$$

Note that in the previous second-order equation, we can replace part of the expressions thereof with the following parameters (able to be calculated based on the previously taken measurements):
If the fault occurs in phase A, the following polarisation voltage values are obtained: $V_{pol}$, $V_{eq}$ and equivalent current $I_{eq}$:

$$V_{pol} = 3 \cdot [-V_2 + I_2 \cdot (Z_{S1} + Z_{L1})]$$

$$V_{eq} = V_a$$

$$I_{eq} = I_a + I_N \cdot K_N$$

If the fault occurs in phase B, the following polarisation voltage values are obtained: $V_{pol}$, $V_{eq}$ and equivalent current $I_{eq}$:

$$V_{pol} = 3 \cdot \mathbf{a} \cdot [-V_2 + I_2 \cdot (Z_{S1} + Z_{L1})]$$

$$V_{eq} = V_b$$

$$I_{eq} = I_b + I_N \cdot K_N$$

where:
**a** is equal to 1∠120° (its value is known in advance).
[It must be noted that this **"a"** is different from the coefficient "a" which, along with the coefficients "b" and "c", goes with the previous second-order equation $a \cdot p^2 + b \cdot p + c = 0$].
If the fault occurs in phase C, the following polarisation voltage values are obtained: $V_{pol}$, $V_{eq}$ and equivalent current $I_{eq}$:

$$V_{pol} = 3 \cdot \mathbf{a}^2 \cdot [-V_2 + I_2 \cdot (Z_{S1} + Z_{L1})]$$

$$V_{eq} = V_c$$

$$I_{eq} = I_c + I_N \cdot K_N$$

where:
**a** is equal to 1∠120°.
Returning to the second-order equation, since it is a quadratic equation, the distance to the fault will be equal to:

$$p = \frac{-b \pm \sqrt{b^2 - 4ac}}{2a}$$

As can be seen, there are two possible solutions. In homogeneous systems, one of these solutions is equal to the sum of the direct sequence impedance of the protected line $Z_{L1}$ plus the direct sequence impedance of the remote source

$Z_{s1}$. In heterogeneous systems, one of the solutions is similar to the sum of the direct sequence impedance of the protected line $Z_{L1}$ plus the direct sequence impedance of the source impedance $Z_{S1}$. In both cases, the distance to the fault is equal to the minimum value between the two values:

$$p = \min \left( \frac{-b + \sqrt{b^2 - 4ac}}{2a}, \frac{-b - \sqrt{b^2 - 4ac}}{2a} \right)$$

In the previous example, it is assumed that the single-phase fault has occurred in phase A. If the fault occurs in phase B, the equations will be the same, except instead of using the magnitudes of phase A, the magnitudes of phase B will be used. If the fault occurs in phase C, the magnitudes of phase C will be used.

Once the distance $p$ to the fault has been accurately calculated, the fault resistance is calculated. To do so, the following equation is solved:

$$R_F = \frac{V_a \cdot (Z_{S1}+Z_{L1}) + p \cdot Z_{L1} \cdot [-V_a - (I_a + I_N \cdot K_N) \cdot (Z_{S1}+Z_{L1})] + p^2 \cdot Z_{L1}{}^2 \cdot (I_a + I_N \cdot K_N)}{3 \cdot [-V_2 + I_2 \cdot (Z_{S1}+Z_{L1})]}$$

TWO-PHASE FAULTS

Figure 12 shows a diagram of a representation of the modelling of a two-phase fault in a network according to a possible embodiment of the invention. The fault has been modelled with two sequence networks 1201, 1202. The network is represented by a strong end modelled as a voltage source **E** 120 with a source impedance $Z_s$ (represented by direct sequence remote source impedances $Z_{s1}$ and reverse sequence $Z_{s2}$) and a modelled weak end that can be represented as a source or load. In the diagram of Figure 12, the measurement unit is connected to the relay (point 85).

In Figure 12, the same variables and parameters denote the same concepts that have been referred to previously, for example in Figure 11.

Based on figure 12 the equations involved are the following:

$$V_1 - I_1 \cdot p \cdot Z_{L1} + I_F \cdot R_F = V_2 - I_2 \cdot p \cdot Z_{L2}$$

$$I_F = \frac{-V_2 + I_2 \cdot (Z_{S2} + Z_{L2})}{(1-p) \cdot Z_{L2} + Z_{S2}}$$

$$Z_{S1} = Z_{S2}$$

$$Z_{L1} = Z_{L2}$$

By solving the four equations, we arrive at the following second-order equation, in which the unknowns are the distance to the fault (p) and the fault resistance ($R_F$):

$$(V_1 - V_2) \cdot (Z_{S1} + Z_{L1}) + p \cdot Z_{L1} \cdot [-(V_1 - V_2) - (I_1 - I_2) \cdot (Z_{S1} + Z_{L1})] + p^2$$
$$\cdot Z_{L1}{}^2 \cdot (I_1 - I_2) = [V_2 - I_2 \cdot (Z_{S1} + Z_{L1})] \cdot R_F$$

If we polarise with the following voltage, the fault resistance will be eliminated, so the only unknown in the equation will be the distance to the fault:

$$[V_2 - I_2 \cdot (Z_{S1} + Z_{L1})]$$

By polarising with this voltage and taking the imaginary part, the previous equation will be as follows:

$$\text{Im}\{[V_2 - I_2 \cdot (Z_{S1} + Z_{L1})]^* \cdot (V_1 - V_2) \cdot (Z_{S1} + Z_{L1})\} + p$$
$$\cdot \text{Im}\{[V_2 - I_2 \cdot (Z_{S1} + Z_{L1})]^* \cdot Z_{L1}$$
$$\cdot [-(V_1 - V_2) - (I_1 - I_2) \cdot (Z_{S1} + Z_{L1})]\} + p^2$$
$$\cdot \text{Im}\{[V_2 - I_2 \cdot (Z_{S1} + Z_{L1})]^* \cdot Z_{L1}{}^2 \cdot (I_1 - I_2)\} = 0$$

It is a second-order equation:

$$a \cdot p^2 + b \cdot p + c = 0$$

where:

$$a = \text{Im}\{[V_2 - I_2 \cdot (Z_{S1} + Z_{L1})]^* \cdot Z_{L1}{}^2 \cdot (I_1 - I_2)\}$$

$$b = \text{Im}\{[V_2 - I_2 \cdot (Z_{S1} + Z_{L1})]^* \cdot Z_{L1} \cdot [-(V_1 - V_2) - (I_1 - I_2) \cdot (Z_{S1} + Z_{L1})]\}$$

$$c = \text{Im}\{[V_2 - I_2 \cdot (Z_{S1} + Z_{L1})]^* \cdot (V_1 - V_2) \cdot (Z_{S1} + Z_{L1})\}$$

Note that in the previous second-order equation, we can replace part of the expressions thereof with the following parameters (able to be calculated based on the previously taken measurements):
If the fault occurs in the phases BC, the following polarisation voltage values are obtained: $V_{pol}, V_{eq}$ and equivalent current $I_{eq}$:

$$V_{pol} = -2 \cdot [-V_2 + I_2 \cdot (Z_{S1} + Z_{L1})]$$

$$V_{eq} = V_1 - V_2 = j\frac{\sqrt{3}}{3} \cdot (V_b - V_c)$$

$$I_{eq} = I_1 - I_2 = j\frac{\sqrt{3}}{3} \cdot (I_b - I_c)$$

If the fault occurs in the phases CA, the following polarisation voltage values are obtained: $V_{pol}, V_{eq}$ and equivalent current $I_{eq}$:

$$V_{pol} = -a \cdot 2 \cdot [-V_2 + I_2 \cdot (Z_{S1} + Z_{L1})]$$

$$V_{eq} = a^2 \cdot V_1 - a \cdot V_2 = j\frac{\sqrt{3}}{3} \cdot (V_c - V_a)$$

$$I_{eq} = a^2 \cdot I_1 - a \cdot I_2 = j\frac{\sqrt{3}}{3} \cdot (I_c - I_a)$$

where:
a is equal to $1\angle120°$, (its value is known in advance).
[It must be noted that this **"a"** is different from the coefficient "a" which, along with the coefficients "b" and "c", goes with the previous second-order equation $a \cdot p^2 + b \cdot p + c = 0$].
If the fault occurs in the phases BA, the following polarisation voltage values are obtained: $V_{pol}, V_{eq}$ and equivalent current $I_{eq}$:

$$V_{pol} = -\mathbf{a}^2 \cdot 2 \cdot [-V_2 + I_2 \cdot (\mathbf{Z}_{S1} + \mathbf{Z}_{L1})]$$

$$V_{eq} = \mathbf{a} \cdot V_1 - \mathbf{a}^2 \cdot V_2 = \mathrm{j}\frac{\sqrt{3}}{3} \cdot (V_a - V_b)$$

$$I_{eq} = \mathbf{a} \cdot I_1 - \mathbf{a}^2 \cdot I_2 = \mathrm{j}\frac{\sqrt{3}}{3} \cdot (I_a - I_b)$$

$$V_{eq} = V_1$$

where:

**a** is equal to $1\angle 120°$, (its value is known in advance).

Returning to the second-order equation, since it is a quadratic equation, the distance to the fault will be equal to:

$$\mathrm{p} = \frac{-b \pm \sqrt{b^2 - 4ac}}{2a}$$

As can be seen, there are two possible solutions. In homogeneous systems, one of these solutions is equal to the sum of the impedance of the protected line $Z_{L1}$ plus the remote source impedance $Z_{s1}$. In heterogeneous systems, one of the solutions is similar to the sum of the impedance of the protected line $Z_{L1}$ plus the impedance of the source impedance $Z_{S1}$. In both cases, the distance to the fault is equal to the minimum value between the two values:

$$p = \min \left(\frac{-b + \sqrt{b^2 - 4ac}}{2a}, \frac{-b - \sqrt{b^2 - 4ac}}{2a}\right)$$

In the previous example it is assumed that the two-phase fault has occurred in phases B and C, and as such the magnitudes of phase A are used. If the fault occurs in phases A and B, the equations will be the same, except instead of using the magnitudes of phase A, the magnitudes of phase C will be used. If the fault occurs in phases A and C, the magnitudes of phase B will be used.

Once the distance to the fault has been accurately calculated, the fault resistance is calculated. To do so, the following equation is solved:

$$\mathrm{R_F} = \frac{(V_1 - V_2)\cdot(\mathbf{Z}_{S1} + \mathbf{Z}_{L1}) + p\cdot\mathbf{Z}_{L1}\cdot[-(V_1 - V_2) - (I_1 - I_2)\cdot(\mathbf{Z}_{S1} + \mathbf{Z}_{L1})] + p^2\cdot\mathbf{Z}_{L1}{}^2\cdot(I_1 - I_2)}{2\cdot[V_2 - I_2\cdot(\mathbf{Z}_{S1} + \mathbf{Z}_{L1})]}$$

THREE-PHASE FAULTS

Figure 13 shows a diagram of a representation of the modelling of a three-phase fault in a network according to a possible embodiment of the invention. The fault has been modelled with a sequence network 1301. The network 1301 is represented by a strong end modelled as a voltage source E 130 with a source impedance $Z_{s1}$ 131 and a weak end that can be represented as a source or load. Two voltage sources (with opposite values) are also represented, which represent the direct sequence prefault voltage (which existed before the fault) at the fault point $V_{Fpref}$. In the diagram of Figure 13, the measurement unit is connected to the relay (point 85).

To calculate the distance of three-phase faults, it is necessary to have measured the values that existed before the fault, since the current that exists before the fault occurs affects the calculation of the distance to the fault. When talking about $I_{pure}$, the prefault values are not taken into account. The current that existed before the fault has an effect on the distance calculation. Figure 14 shows a diagram of a representation of the modelling of a sequence network in a prefault situation according to a possible embodiment of the invention. The network is represented by a strong end 1401 modelled as a voltage source E 140 with a remote source direct sequence impedance $Z_{s1}$ 141 and a weak end 1402 that can be represented as a source or load. In the diagram of Figure 14, the measurement unit is connected to the relay (point 85). In figure 14, $I_{1pref}$ denotes the direct sequence prefault current at the measurement point and $V_{1pref}$ denotes the direct sequence prefault voltage at the measurement point (source or load).

Figure 15 shows a schematic representation of the modelling of a pure (i.e., after removing the prefault effect) three-phase fault in a network, according to a possible embodiment of the invention. The fault has been modelled with a sequence network. The network is represented by a strong end 1501 modelled as a remote source direct sequence impedance $Z_{s1}$ and a weak end 1502 that can be represented as a source or load. In the diagram of Figure 15, the measurement unit is connected to the relay (point 85). In Figure 15, $I_{1remote}$ denotes the direct sequence fault current at the remote end in the case of a three-phase fault, eliminating the prefault value, $I_{1pure}$ denotes the direct sequence fault current at the measurement point without the prefault value, $V_{1pure}$ denotes the direct sequence fault voltage at the measurement point without the prefault value and $V_{Fpref}$ denotes the direct sequence prefault voltage at the fault point. As previously explained, at the measurement point 85, the measurements of $I_a$, $I_b$, $I_c$, $V_a$, $V_b$ and $V_c$ are taken. At the measurement point, or alternatively if these measurements are sent to a control system, $I_0$, $I_1$, $I_2$, $V_0$, $V_1$, $V_2$, $I_{eq}$, $V_{eq}$, $V_{pol}$ are calculated based on the measurements.

In Figures 13 to 15, the same variables and parameters denote the same concepts that have been previously referred to, such as in Figures 11 and 12.

Based on Figures 13, 14 and 15, the equations involved are the following:

$$V_{1pref} - I_{1pref} \cdot p \cdot Z_{L1} = V_{Fpref}$$

$$V_{1pure} - I_{1pure} \cdot p \cdot Z_{L1} = I_F \cdot R_F - V_{Fpref}$$

$$V_{Fpref} - I_F \cdot R_F = I_{1remote} \cdot (Z_{S1} + (1-p) \cdot Z_{L1})$$

$$I_F = I_{1remote} + I_{1pure}$$

By solving the four equations we arrive at the following second-order equation, in which the unknowns are the distance to the fault (p) and fault resistance ($R_F$):

$$\begin{aligned}
&\left(V_{1pure} + V_{1pref}\right) \cdot (Z_{S1} + Z_{L1}) + p \cdot Z_{L1} \\
&\quad \cdot \left[-\left(V_{1pure} + V_{1pref}\right) - \left(I_{1pure} + I_{1pref}\right) \cdot (Z_{S1} + Z_{L1})\right] + p^2 \cdot Z_{L1}{}^2 \\
&\quad \cdot \left(I_{1pure} + I_{1pref}\right) = R_F \cdot \left(-V_{1pure} + I_{1pure} \cdot (Z_{S1} + Z_{L1})\right)
\end{aligned}$$

If we polarise with the following voltage, we will be able to eliminate the fault resistance, so the only unknown in the equation will be the distance to the fault:

$$\left(-V_{1pure} + I_{1pure} \cdot (Z_{S1} + Z_{L1})\right)$$

By polarising with this voltage and taking the imaginary part, the previous equation will be as follows:

$$\begin{aligned}
&\mathrm{Im}\left\{\left[-V_{1pure} + I_{1pure} \cdot (Z_{S1} + Z_{L1})\right]^* \cdot \left(V_{1pure} + V_{1pref}\right) \cdot (Z_{S1} + Z_{L1})\right\} + p \\
&\quad \cdot \mathrm{Im}\left\{\left[-V_{1pure} + I_{1pure} \cdot (Z_{S1} + Z_{L1})\right]^* \cdot Z_{L1}\right. \\
&\quad \left. \cdot \left[-\left(V_{1pure} + V_{1pref}\right) - \left(I_{1pure} + I_{1pref}\right) \cdot (Z_{S1} + Z_{L1})\right]\right\} + p^2 \\
&\quad \cdot \mathrm{Im}\left\{\left[-V_{1pure} + I_{1pure} \cdot (Z_{S1} + Z_{L1})\right]^* \cdot Z_{L1}{}^2 \cdot \left(I_{1pure} + I_{1pref}\right)\right\} = 0
\end{aligned}$$

If we consider that:

$$V_1 = V_{1pure} + V_{1pref}$$

$$I_1 = I_{1pure} + I_{1pref}$$

$$\text{Im}\left\{\left[-V_{1pure} + I_{1pure} \cdot (Z_{S1} + Z_{L1})\right]^* \cdot V_1 \cdot (Z_{S1} + Z_{L1})\right\} + p$$
$$\cdot \text{Im}\left\{\left[-V_{1pure} + 1_{1pure} \cdot (Z_{S1} + Z_{L1})\right]^* \cdot Z_{L1}\right.$$
$$\left. \cdot \left[-V_1 - I_1 \cdot (Z_{S1} + Z_{L1})\right]\right\} + p^2$$
$$\cdot \text{Im}\left\{\left[-V_{1pure} + I_{1pure} \cdot (Z_{S1} + Z_{L1})\right]^* \cdot Z_{L1}^2 \cdot I_1\right\} = 0$$

It is a second-order equation:

$$a \cdot p^2 + b \cdot p + c = 0$$

where:

$$a = \text{Im}\left\{\left[-V_{1pure} + I_{1pure} \cdot (Z_{S1} + Z_{L1})\right]^* \cdot Z_{L1}^2 \cdot I_1\right\}$$

$$b = \text{Im}\left\{\left[-V_{1pure} + I_{1pure} \cdot (Z_{S1} + Z_{L1})\right]^* \cdot Z_{L1} \cdot \left[-V_1 - I_1 \cdot (Z_{S1} + Z_{L1})\right]\right\}$$

$$c = \text{Im}\left\{\left[-V_{1pure} + I_{1pure} \cdot (Z_{S1} + Z_{L1})\right]^* \cdot V_1 \cdot (Z_{S1} + Z_{L1})\right\}$$

Note that in the previous second-order equation, we can replace part of the expressions thereof with the following parameters (able to be calculated based on the previously taken measurements):

$$V_{pol} = \left[-V_{1pure} + I_{1pure} \cdot (Z_{S1} + Z_{L1})\right]$$

$$V_{eq} = V_1$$

$$I_{eq} = I_1$$

Returning to the second-order equation, since it is a quadratic equation, the distance to the fault will be equal to:

$$p = \frac{-b \pm \sqrt{b^2 - 4ac}}{2a}$$

As can be seen, there are two possible solutions. In homogeneous systems, one of these solutions is equal to the sum of the impedance of the protected line $Z_{L1}$ plus the remote source impedance $Z_{s1}$. In heterogeneous systems, one of the solutions is similar to the sum of the impedance of the protected line $Z_{L1}$ plus the impedance of the source impedance $Z_{s1}$. In both cases, the distance to the fault is equal to the minimum value between the two values:

$$p = \min\left(\frac{-b + \sqrt{b^2 - 4ac}}{2a}, \frac{-b - \sqrt{b^2 - 4ac}}{2a}\right)$$

Once the distance to the fault has been accurately calculated, the fault resistance is calculated. To do so, the following equation is solved:

$$R_F = \frac{V_1 \cdot (Z_{S1} + Z_{L1}) + p \cdot Z_{L1} \cdot \left[-V_1 - I_1 \cdot (Z_{S1} + Z_{L1})\right] + p^2 \cdot Z_{L1}^2 \cdot I_1}{-V_{1pure} + I_{1pura} \cdot (Z_{S1} + Z_{L1})}$$

Based on the three previous solved equations related to the respective single-phase, two-phase and three-phase fault, in turn derived from sequence network theory, it can be generally stated that the value of the distance to the fault in values of unit $p$ is calculated by the following expression, in which the polarisation voltage $V_{pol,eq}$ and equivalent current $I_{eq}$

parameters are specifically calculated depending on whether the fault is single-phase, two-phase or three-phase:

$$\mathrm{Im}\left[\left(\boldsymbol{V_{pol}}\right)^{*} \cdot \left(\mathbf{Z_{L1}}\right)^{2} \cdot \boldsymbol{I_{eq}}\right] \cdot p^{2} + \mathrm{Im}\left[-\left(\boldsymbol{V_{pol}}\right)^{*} \cdot \mathbf{Z_{L1}} \cdot \left(\boldsymbol{V_{eq}} + \boldsymbol{I_{eq}} \cdot (\mathbf{Z_{S1}} + \mathbf{Z_{L1}})\right)\right] \cdot p \\ + \mathrm{Im}\left[\left(\boldsymbol{V_{pol}}\right)^{*} \cdot \boldsymbol{V_{eq}} \cdot (\mathbf{Z_{S1}} + \mathbf{Z_{L1}})\right] = 0$$

Which is a second-order equation where:

$$a = \mathrm{Im}\left[\left(\boldsymbol{V_{pol}}\right)^{*} \mathbf{Z_{L1}}^{2} \cdot \boldsymbol{I_{eq}}\right]$$

$$b = \mathrm{Im}\left\{-\left(\boldsymbol{V_{pol}}\right)^{*} \cdot \mathbf{Z_{L1}} \cdot \left[\boldsymbol{V_{eq}} + \boldsymbol{I_{eq}} \cdot (\mathbf{Z_{S1}} + \mathbf{Z_{L1}})\right]\right\}$$

$$c = \mathrm{Im}\left[\left(\boldsymbol{V_{pol}}\right)^{*} \cdot \boldsymbol{V_{eq}} \cdot (\mathbf{Z_{S1}} + \mathbf{Z_{L1}})\right]$$

where $\boldsymbol{V_{pol}}$ is the polarisation voltage; $\mathbf{Z_{L1}}$ is the direct sequence impedance of the protected line; $\boldsymbol{I_{eq}}$ is the equivalent current, which in the case of single-phase faults corresponds to the compensated current; $\boldsymbol{V_{eq}}$ is the equivalent voltage; $\mathbf{Z_{S1}}$ is the remote source direct sequence impedance; $\mathbf{Z_{L1}}$ is the direct sequence impedance of the protected line. It must be mentioned that the polarisation voltage is used to be able to remove the fault resistance from the previous equation; and the equivalent current and voltage are calculated based on the phase current and voltage measurements, respectively. The values of $\boldsymbol{V_{pol}}$, $\boldsymbol{I_{eq}}$ and $\boldsymbol{V_{eq}}$ are calculated with measurements taken from the fault situation, specifically depending on whether the fault is single-phase, two-phase or three-phase. $\mathbf{Z_{S1}}$ It is a value that must be calculated before the fault occurs. This value is calculated with two different values of $V_1$ (direct sequence voltage at the measurement point) and two different values of $I_1$ (direct sequence current at the measurement point). These values are obtained when a variation in $V_1$ or in $I_1$ occurs in a no-fault situation. When a variation occurs between these two magnitudes, two $V_1$ values (one of those values is before the variation and the other value is after the variation) and two $I_1$ values (one of those values is before the variation and the other value is after the variation) are obtained. $V_1$ and $I_1$ are calculated based on the measured values of phase A current at the measurement point ($I_a$), phase B current at the measurement point ($I_b$), phase C current at the measurement point ($I_c$), phase A voltage at the measurement point ($V_a$), phase B voltage at the measurement point ($V_b$) and phase C voltage at the measurement point ($V_c$).

And, as explained in each specific case, mathematically there are two possible solutions:

$$p = \frac{-b \pm \sqrt{b^2 - 4ac}}{2a}$$

The correct solution is the minimum of the two:

$$p = \min\left(\frac{-b + \sqrt{b^2 - 4ac}}{2a}, \frac{-b - \sqrt{b^2 - 4ac}}{2a}\right)$$

By multiplying the distance in values per unit with the reactance of the line, the reactance X between the measurement point and the fault is obtained:

$$X = p \cdot \mathrm{X_{L1}}$$

where $\mathrm{X_{L1}}$ is the direct sequence reactance of the protected line.

The value of fault resistance $R_F$ is calculated as follows:

$$\mathrm{R_F} = \mathrm{R} = \frac{\boldsymbol{V_{eq}} \cdot (\mathbf{Z_{S1}} + \mathbf{Z_{L1}}) + p \cdot \mathbf{Z_{L1}} \cdot \left[-\boldsymbol{V_{eq}} - \boldsymbol{I_{eq}} \cdot (\mathbf{Z_{S1}} + \mathbf{Z_{L1}})\right] + p^2 \cdot (\mathbf{Z_{L1}})^2 \cdot \boldsymbol{I_{eq}}}{\boldsymbol{V_{pol}}}$$

where R is the seen resistance from the measurement point to the fault point.

The rule for determining whether the fault is inside the zone is: If $X < X_R$ and $R < R_R$ the fault has occurred inside the range of the distance unit.

It should be noted that, to locate the fault on a plane, it is necessary to calculate R and X. The reactance X represents the distance to the fault (location).

The weaker the end from which the line is protected, the less precision there is in the distance calculation in heterogeneous networks and in faults with non-zero resistance. This occurs due to the fact that when there are two ends that feed the fault, each end only measures the contribution thereof (see, as an example, the electrical system in Figure 6).

It will then be shown that the value of the distance to the fault is the minimum of the two possible values.

Let us suppose that the coefficients $a$, $b$ and $c$ are purely imaginary, meaning that they contain no real part. In this case, the coefficients can be represented as follows:

$$a = \left(V_{pol}\right)^{*} Z_{L1}{}^{2} \cdot I_{eq}$$

$$b = -\left(V_{pol}\right)^{*} \cdot Z_{L1} \cdot \left[V_{eq} + I_{eq} \cdot (Z_{S1} + Z_{L1})\right]$$

$$c = \left(V_{pol}\right)^{*} \cdot V_{eq} \cdot (Z_{S1} + Z_{L1})$$

The distance to the fault is calculated with these coefficients:

$$p = \frac{-b \pm \sqrt{b^2 - 4ac}}{2a}$$

Substituting the coefficients:

$$p = \frac{(V_{pol})^{*} \cdot Z_{L1} \cdot [V_{eq} + I_{eq} \cdot (Z_{S1} + Z_{L1})] \pm \sqrt{\left\{(V_{pol})^{*} \cdot Z_{L1} \cdot [V_{eq} + I_{eq} \cdot (Z_{S1} + Z_{L1})]\right\}^{2} - 4 \cdot (V_{pol})^{*} Z_{L1}{}^{2} \cdot I_{eq} \cdot (V_{pol})^{*} \cdot V_{eq} \cdot (Z_{S1} + Z_{L1})}}{2 \cdot (V_{pol})^{*} Z_{L1}{}^{2} \cdot I_{eq}}$$

$$p = \frac{\left[V_{eq} + I_{eq} \cdot (Z_{S1} + Z_{L1})\right] \pm \sqrt{\left[V_{eq} + I_{eq} \cdot (Z_{S1} + Z_{L1})\right]^{2} - 4 \cdot I_{eq} \cdot V_{eq} \cdot (Z_{S1} + Z_{L1})}}{2 \cdot Z_{L1} \cdot I_{eq}}$$

$$p = \frac{\left[V_{eq} + I_{eq} \cdot (Z_{S1} + Z_{L1})\right] \pm \sqrt{\left[V_{eq} - I_{eq} \cdot (Z_{S1} + Z_{L1})\right]^{2}}}{2 \cdot Z_{L1} \cdot I_{eq}}$$

Simplifying the previous expression, we arrive at the two possible distance values $p_1$, $p_2$:

$$p = \frac{\left[V_{eq} + I_{eq} \cdot (Z_{S1} + Z_{L1})\right] \pm \left[V_{eq} - I_{eq} \cdot (Z_{S1} + Z_{L1})\right]}{2 \cdot Z_{L1} \cdot I_{eq}}$$

$$p_1 = \frac{V_{eq}}{Z_{L1} \cdot I_{eq}}$$

$$p_2 = \frac{(Z_{S1} + Z_{L1})}{Z_{L1}}$$

One of the two possible values is always positioned at the opposite end (a point that is between the equivalent voltage source of the strong end and the source impedance of the remote end), meaning at the point ($Z_{S1} + Z_{L1}$). This value is the incorrect value and will always be greater than the other value. This is the reason why the correct value will be the minimum value of the two values:

$$p = \frac{V_{eq}}{Z_{L1} \cdot I_{eq}}$$

The previous equations are true when the faults are clear, meaning the resistive component thereof is equal to zero. In the case of resistive faults, in the maximum value, the distance is not exactly equal to ($Z_{S1} + Z_{L1}$), but it will be very close. In any case, the correct value will always be the minimum of the two values.

Below is an example in which a single-phase fault has been simulated at 80% of the line (that is, if the line was, for example, 100 km, the fault is simulated at 80 km), and which has a fault resistance equal to 3Ω. The simulation diagram is represented in Figure 10. It will be shown that the algorithm of the invention and the distance unit that implements the same, are capable of identifying the distance to the fault (80%) and the fault resistance (3 Ω). The simulation has been carried out using the Matlab tool, version 2020b.

For the simulation, the following values (imposed, by design) have been chosen:
The direct and reverse sequence impedances of the line are: $Z_{L1}$ = 6.989∠70.734° Ω and $Z_{L0}$ = 22.436∠68.398° Ω

The source impedance is: $Z_{S1}$ = 9.579∠74.393° Ω

The homopolar compensation factor is: $K_N$ = 0.737∠ - 3.392° Ω

With these simulated values, the fault currents and voltages gathered are the following:
$I_a$ = 963.507∠ - 11.549° A, $I_b$ = 367.176∠ - 52.603° A, $I_c$ = 129.452° A
$V_a$ = 13.291L25.458° kV , $V_b$ = 18.901∠ - 80.459° kV, $V_c$ = 19.52∠149.275° kV

The direct and reverse sequence currents and voltages are: $I_1$ = 358.82∠13.09° A, $I_2$ = 243.236∠ - 20.6484° A, $V_1$ = 17.147∠32.043° kV, $V_2$ = 3.114∠ - 129.604° kV

The neutral current is: $I_N$ =

The polarisation voltage, equivalent voltage and equivalent current are: $V_{pol}$ = 3 · [-$V_2$ + $I_2$ · ($Z_{S1}$ + $Z_{L1}$)] = 21.424L51.414° kV, $V_{eq}$ = $V_a$ = 13.291∠25.458° kV,
$I_{eq} = I_a + I_N \cdot K_N = A$

The coefficients are equal to: $a$ = Im[($V_{pol}$)* · $Z_{L1}^2$ · $I_{eq}$] = 1.81 × 10⁹

$$b = \text{Im}\left\{-\left(V_{pol}\right)^{*} \cdot Z_{L1} \cdot \left[V_{eq} + I_{eq} \cdot (Z_{S1} + Z_{L1})\right]\right\} = -5.748 \times 10^9$$

$$c = \text{Im}\left[\left(V_{pol}\right)^{*} \cdot V_{eq} \cdot (Z_{S1} + Z_{L1})\right] = 3.442 \times 10^9$$

The two measured distances are equal to:

$$p_1 = \frac{-b + \sqrt{b^2 - 4ac}}{2a} = 2.374$$

$$p_2 = \frac{-b - \sqrt{b^2 - 4ac}}{2a} = 0.801$$

The minimum between the two values is 0.801, which shows that it correctly calculates the distance to the fault (it must be noted that a fault distance of 80% had been defined):

$$p = \min(p_1, p_2) = p_2 = 0.801$$

The fault resistance is then calculated:

$$R_F = \frac{V_{eq} \cdot (Z_{S1} + Z_{L1}) + p \cdot Z_{L1} \cdot \left[-V_{eq} - I_{eq} \cdot (Z_{S1} + Z_{L1})\right] + p^2 \cdot Z_{L1}^2 \cdot I_{eq}}{V_{pol}} = 2.957\Omega$$

It can be seen that the algorithm correctly determines the value of the fault resistance (it must be noted that a fault resistance equal to 3Ω had been defined).

The following table shows the results obtained in other simulations, in different faults with and without fault resistance and in the case of single-phase, two-phase and three-phase faults:

| Fault Type | Fault point (f.p.) | Fault Resistance (Ω) | Calculated distance | Calculated resistance (Ω) |
|---|---|---|---|---|
| AG | 0.8 | 0 | 0.8 | -0.002 |
| AG | 0.8 | 3 | 0.801 | 2.957 |
| BC | 0.8 | 0 | 0.805 | -0.004 |
| BC | 0.8 | 3 | 0.79 | 3.044 |
| ABC | 0.8 | 0 | 0.802 | 0.012 |
| ABC | 0.8 | 5 | 0.813 | 4.9 |

This shows the excellent precision of the proposed algorithm in calculating distance and resistance.

In this text, the term "comprises" and its derivations (such as "comprising", etc.) must not be understood in an exclusive sense, i.e., these terms must not be interpreted as excluding the possibility of what is described and defined including further elements, steps, etc.

In the context of the present invention, the term "approximately" and terms of the family thereof (such as "approximate", etc.) should be interpreted as indicating values very close to those that accompany said term. That is, a deviation within reasonable limits from an exact value should be accepted, because a person skilled in the art will understand that such a deviation from the indicated values may be unavoidable due to measurement inaccuracies, etc. The same applies to the terms "some", "around" and "substantially".

The invention is obviously not limited to the specific embodiment(s) that have been described, rather it also covers any variation that may be considered by any person skilled in the art (for example, in relation to the choice of materials, dimensions, components, configuration, etc.), within the general scope of the invention as defined in the claims.

## Claims

1.   A computer-implemented method for determining a distance at which a fault occurs on a protected power line of an electric power system, wherein the power line is protected from a weak end of the power line, comprising:

- measuring the following magnitudes at a measurement point (85) of the protected line from a weak end in a fault situation: phase A current at the measurement point ($I_a$), phase B current at the measurement point ($I_b$), phase C current at the measurement point ($I_c$), phase A voltage at the measurement point ($V_a$), phase B voltage at the measurement point ($V_b$) and phase C voltage at the measurement point ($V_c$);

- based on the previous measurements, calculating the following magnitudes of the power line: homopolar sequence voltage at the measurement point ($V_0$), direct sequence voltage at the measurement point ($V_1$), reverse sequence voltage at the measurement point ($V_2$), homopolar sequence current at the measurement point ($I_0$), direct sequence current at the measurement point ($I_1$), reverse sequence current at the measurement point ($I_2$), equivalent voltage ($V_{eq}$), equivalent current ($I_{eq}$) and polarisation voltage ($V_{pol}$);

- calculating the distance $p$ at which a single-phase, two-phase or three-phase fault occurs in the protected power line based on the following formula:

$$\text{Im}\left[\left(V_{pol}\right)^* \cdot Z_{L1}^2 \cdot I_{eq}\right] \cdot p^2 + \text{Im}\left\{-\left(V_{pol}\right)^* \cdot Z_{L1} \cdot \left[V_{eq} + I_{eq} \cdot (Z_{S1} + Z_{L1})\right]\right\} \cdot p + \text{Im}\left[\left(V_{pol}\right)^* \cdot V_{eq} \cdot (Z_{S1} + Z_{L1})\right] = 0$$

where $Z_{L1}$ is the direct sequence impedance of the protected line and is known; and $Z_{S1}$ is the direct sequence impedance of the remote source and has been calculated before the fault occurs based on direct sequence voltage values at the measurement point $V_1$ and direct sequence current values at the measurement point $I_1$ at two different moments in a no-fault situation;

where the value of the distance to the fault is the minimum solution of the following two possible solutions:

$$p = \min \left( \frac{-b + \sqrt{b^2 - 4ac}}{2a}, \frac{-b - \sqrt{b^2 - 4ac}}{2a} \right)$$

where

$$a = \text{Im}\left[ \left( V_{pol} \right)^* Z_{L1}{}^2 \cdot I_{eq} \right]$$

$$b = \text{Im}\left\{ -\left( V_{pol} \right)^* \cdot Z_{L1} \cdot \left[ V_{eq} + I_{eq} \cdot (Z_{S1} + Z_{L1}) \right] \right\}$$

$$c = \text{Im}\left[ \left( V_{pol} \right)^* \cdot V_{eq} \cdot (Z_{S1} + Z_{L1}) \right]$$

2.  The method of claim 1, further comprising calculating, based on the distance to the fault $p$, the reactance to the fault point from the measurement point:

$$X = p \cdot X_{L1}$$

where $X_{L1}$ is the direct sequence reactance of the protected line.

3.  The method of any of claims 1 or 2, further comprising calculating, based on the distance to the fault $p$, the fault resistance:

$$R_F = R = \frac{V_{eq} \cdot (Z_{S1} + Z_{L1}) + p \cdot Z_{L1} \cdot [-V_{eq} - I_{eq} \cdot (Z_{S1} + Z_{L1})] + p^2 \cdot (Z_{L1})^2 \cdot I_{eq}}{V_{pol}}$$

where R is the resistance seen from the measurement point to the fault point.

4.  The method of claims 2 and 3, further comprising:

    - comparing the reactance at the fault point from the measurement point X with a reactive range set value $X_R$ previously chosen;
    - comparing the resistance seen from the measurement point to the fault point R with a resistive range set value $R_R$ previously chosen; and
    - if $X < X_R$ and $R < R_R$:

        - determining that the fault has occurred inside the range of a distance unit;
        - optionally, actuating a switch to isolate the fault from the rest of the electric power system.

5.  The method of any of the preceding claims, wherein, if the fault is single-phase:

    - if the fault occurs in phase A, the values of polarisation voltage $V_{pol}$, equivalent voltage $V_{eq}$ and equivalent current $I_{eq}$ are obtained as follows:

$$V_{pol} = 3 \cdot [-V_2 + I_2 \cdot (Z_{S1} + Z_{L1})]$$

$$V_{eq} = V_a$$

$$I_{eq} = I_a + I_N \cdot K_N$$

where:

$I_N$ is the neutral current at the measurement point, which is $I_N = 3 \cdot I_0$

$K_N$ is the homopolar sequence compensation factor, $\quad K_N = \dfrac{Z_{L0} - Z_{L1}}{3 \cdot Z_{L1}}$

- if the fault occurs in phase B, the values of polarisation voltage $V_{pol}$, equivalent voltage $V_{eq}$ and equivalent current $I_{eq}$ are obtained as follows

$$V_{pol} = 3 \cdot a \cdot [-V_2 + I_2 \cdot (Z_{S1} + Z_{L1})]$$

$$V_{eq} = V_b$$

$$I_{eq} = I_b + I_N \cdot K_N$$

where:

a is equal to $1\angle 120°$, and is known in advance,
$I_N$ is the neutral current at the measurement point, which is $I_N = 3 \cdot I_0$

$K_N$ is the homopolar sequence compensation factor, $\quad K_N = \dfrac{Z_{L0} - Z_{L1}}{3 \cdot Z_{L1}}$

- if the fault occurs in phase C, the values of polarisation voltage $V_{pol}$, equivalent voltage $V_{eq}$ and equivalent current $I_{eq}$ values, are obtained as follows:

$$V_{pol} = 3 \cdot a^2 \cdot [-V_2 + I_2 \cdot (Z_{S1} + Z_{L1})]$$

$$V_{eq} = V_c$$

$$I_{eq} = I_c + I_N \cdot K_N$$

where:

a is equal to $1\angle 120°$, and is known in advance,
$I_N$ is the neutral current at the measurement point, $I_N = 3 \cdot I_0$

$K_N$ is the homopolar sequence compensation factor, $\quad K_N = \dfrac{Z_{L0} - Z_{L1}}{3 \cdot Z_{L1}}$

6. The method of any of claims 1-4, wherein, if the fault is two-phase:

- if the fault occurs in the phases BC, the values of polarisation voltage $V_{pol}$, equivalent voltage $V_{eq}$ and equivalent current $I_{eq}$ are obtained as follows:

$$V_{pol} = -2 \cdot [-V_2 + I_2 \cdot (Z_{S1} + Z_{L1})]$$

$$V_{eq} = V_1 - V_2 = j\frac{\sqrt{3}}{3} \cdot (V_b - V_c)$$

$$I_{eq} = I_1 - I_2 = j\frac{\sqrt{3}}{3} \cdot (I_b - I_c)$$

- if the fault occurs in the phases CA, the values of polarisation voltage $V_{pol}$, equivalent voltage $V_{eq}$ and equivalent current $I_{eq}$ are obtained as follows:

$$V_{pol} = -\mathbf{a} \cdot 2 \cdot \left[-V_2 + I_2 \cdot (\mathbf{Z}_{S1} + \mathbf{Z}_{L1})\right]$$

$$V_{eq} = \mathbf{a}^2 \cdot V_1 - \mathbf{a} \cdot V_2 = j\frac{\sqrt{3}}{3} \cdot (V_c - V_a)$$

$$I_{eq} = \mathbf{a}^2 \cdot I_1 - \mathbf{a} \cdot I_2 = j\frac{\sqrt{3}}{3} \cdot (I_c - I_a)$$

where:
a is equal to $1\angle 120°$, and is known in advance
- if the fault occurs in the phases BA, the values of polarisation voltage $V_{pol}$, equivalent voltage $V_{eq}$ and equivalent current $I_{eq}$, are obtained as follows:

$$V_{pol} = -\mathbf{a}^2 \cdot 2 \cdot \left[-V_2 + I_2 \cdot (\mathbf{Z}_{S1} + \mathbf{Z}_{L1})\right]$$

$$V_{eq} = \mathbf{a} \cdot V_1 - \mathbf{a}^2 \cdot V_2 = j\frac{\sqrt{3}}{3} \cdot (V_a - V_b)$$

$$I_{eq} = \mathbf{a} \cdot I_1 - \mathbf{a}^2 \cdot I_2 = j\frac{\sqrt{3}}{3} \cdot (I_a - I_b)$$

$$V_{eq} = V_1$$

where:
a is equal to $1\angle 120°$, and is known in advance.

7. The method of any of claims 1-4, wherein, if the fault is three-phase, the values of polarisation voltage $V_{pol}$, equivalent voltage $V_{eq}$ and equivalent current $I_{eq}$, are obtained as follows:

$$V_{pol} = \left[-V_{1pure} + I_{1pure} \cdot (\mathbf{Z}_{S1} + \mathbf{Z}_{L1})\right]$$

$$V_{eq} = V_1$$

$$I_{eq} = I_1$$

where

$V_{1pure}$ is the direct sequence fault voltage at the measurement point where the prefault value has been eliminated,
$I_{1pure}$ is the direct sequence fault current at the measurement point where the prefault value has been eliminated.

8. A distance unit for determining the distance at which a fault occurs on a protected power line of an electric power system, wherein the power line is protected from a weak end of the power line, comprising:

- means for measuring the following magnitudes at a measurement point (85) of the protected line from a weak end in a fault situation: phase A current at the measurement point ($I_a$), phase B current at the measurement point ($I_b$), phase C current at the measurement point ($I_c$), phase A voltage at the measurement point ($V_a$), phase B voltage at the measurement point ($V_b$) and phase C voltage at the measurement point ($V_c$);

- means for, based on the previous measurements, calculating the following magnitudes of the power line: homopolar sequence voltage at the measurement point ($V_0$), direct sequence voltage at the measurement point ($V_1$), reverse sequence voltage at the measurement point ($V_2$), homopolar sequence current at the measurement point ($I_0$), direct sequence current at the measurement point ($I_1$), reverse sequence current at the measurement point ($I_2$), equivalent voltage ($V_{eq}$), equivalent current ($I_{eq}$) and polarisation voltage ($V_{pol}$);

- means for calculating distance $p$ at which a single-phase, two-phase or three-phase fault occurs in the protected power line based on the following formula:

$$\mathrm{Im}\left[\left(V_{pol}\right)^* \cdot \mathbf{Z}_{\mathrm{L1}}{}^2 \cdot I_{eq}\right] \cdot p^2 + \mathrm{Im}\left\{-\left(V_{pol}\right)^* \cdot \mathbf{Z}_{\mathrm{L1}} \cdot \left[V_{eq} + I_{eq} \cdot (\mathbf{Z}_{\mathrm{S1}} + \mathbf{Z}_{\mathrm{L1}})\right]\right\} \cdot p$$
$$+ \mathrm{Im}\left[\left(V_{pol}\right)^* \cdot V_{eq} \cdot (\mathbf{Z}_{\mathrm{S1}} + \mathbf{Z}_{\mathrm{L1}})\right] = 0$$

where $\mathbf{Z_{L1}}$ is the direct sequence impedance of the protected line and is known; and $\mathbf{Z_{S1}}$ is the direct sequence impedance of the remote source and has been calculated before the fault occurs based on direct sequence voltage values at the measurement point $V_1$ and direct sequence current values at the measurement point $I_1$ at two different moments in a no-fault situation;

where the value of the distance to the fault is the minimum solution of the following two possible solutions:

$$p = \min \left(\frac{-b + \sqrt{b^2 - 4ac}}{2a}, \frac{-b - \sqrt{b^2 - 4ac}}{2a}\right)$$

where

$$a = \mathrm{Im}\left[\left(V_{pol}\right)^* \mathbf{Z}_{\mathrm{L1}}{}^2 \cdot I_{eq}\right]$$

$$b = \mathrm{Im}\left\{-\left(V_{pol}\right)^* \cdot \mathbf{Z}_{\mathrm{L1}} \cdot \left[V_{eq} + I_{eq} \cdot (\mathbf{Z}_{\mathrm{S1}} + \mathbf{Z}_{\mathrm{L1}})\right]\right\}$$

$$c = \mathrm{Im}\left[\left(V_{pol}\right)^* \cdot V_{eq} \cdot (\mathbf{Z}_{\mathrm{S1}} + \mathbf{Z}_{\mathrm{L1}})\right]$$

9. The distance unit of claim 8, further comprising means for calculating, based on the distance to the fault $p$, the reactance to the fault point from the measurement point:

$$X = p \cdot \mathrm{X}_{\mathrm{L1}}$$

where $\mathrm{X}_{\mathrm{L1}}$ is the direct sequence reactance of the protected line.

10. The distance unit of any of claims 8 or 9, further comprising means for calculating, based on the fault distance $p$, the fault resistance:

$$\mathrm{R}_{\mathrm{F}} = \mathrm{R} = \frac{V_{eq} \cdot (\mathbf{Z}_{\mathrm{S1}} + \mathbf{Z}_{\mathrm{L1}}) + p \cdot \mathbf{Z}_{\mathrm{L1}} \cdot \left[-V_{eq} - I_{eq} \cdot (\mathbf{Z}_{\mathrm{S1}} + \mathbf{Z}_{\mathrm{L1}})\right] + p^2 \cdot (\mathbf{Z}_{\mathrm{L1}})^2 \cdot I_{eq}}{V_{pol}}$$

where R is the resistance seen from the measurement point to the fault point.

11. The distance unit of claims 9 and 10, further comprising:

- means for comparing the reactance to the fault point from the measurement point $X$ with a previously established reactive range set value $X_R$;
- means for comparing the resistance seen from the measurement point to the fault point R with a previously chosen resistive range set value $R_R$; and
- means for, if $X < X_R$ and $R < R_R$:

- determining that the fault has occurred inside the range of a distance unit;
- optionally, actuating a switch to isolate the fault from the rest of the electric power system.

12. The distance unit of any of claims 8-11, wherein, if the fault is single-phase:

- if the fault occurs in phase A, the values of polarisation voltage $V_{pol}$, equivalent voltage $V_{eq}$ and equivalent current $I_{eq}$, are obtained as follows:

$$V_{pol} = 3 \cdot [-V_2 + I_2 \cdot (Z_{S1} + Z_{L1})]$$

$$V_{eq} = V_a$$

$$I_{eq} = I_a + I_N \cdot K_N$$

where:

$I_N$ is the neutral current at the measurement point, which is $I_N = 3 \cdot I_0$

$K_N$ is the homopolar sequence compensation factor, $\quad K_N = \dfrac{Z_{L0} - Z_{L1}}{3 \cdot Z_{L1}}$

- if the fault occurs in phase B, the values of polarisation voltage $V_{pol}$, equivalent voltage $V_{eq}$ and equivalent current $I_{eq}$, are obtained as follows

$$V_{pol} = 3 \cdot a \cdot [-V_2 + I_2 \cdot (Z_{S1} + Z_{L1})]$$

$$V_{eq} = V_b$$

$$I_{eq} = I_b + I_N \cdot K_N$$

where:

**a** is equal to $1\angle 120°$, and is known in advance,
$I_N$ is the neutral current at the measurement point, which is $I_N = 3 \cdot I_0$

$K_N$ is the homopolar sequence compensation factor, $\quad K_N = \dfrac{Z_{L0} - Z_{L1}}{3 \cdot Z_{L1}}$

- if the fault occurs in phase C, the values of polarisation voltage $V_{pol}$, equivalent voltage $V_{eq}$ and equivalent current $I_{eq}$, are obtained as follows:

$$V_{pol} = 3 \cdot a^2 \cdot [-V_2 + I_2 \cdot (Z_{S1} + Z_{L1})]$$

$$V_{eq} = V_c$$

$$I_{eq} = I_c + I_N \cdot K_N$$

where:

**a** is equal to $1\angle 120°$, and is known in advance,
$I_N$ is the neutral current at the measurement point, $I_N = 3 \cdot I_0$

$K_N$ is the homopolar sequence compensation factor, $\quad K_N = \dfrac{Z_{L0} - Z_{L1}}{3 \cdot Z_{L1}}$

**13.** The distance unit of any of claims 8-11, wherein, if the fault is two-phase:

- if the fault occurs in the phases BC, the values of polarisation voltage $V_{pol}$, equivalent voltage $V_{eq}$ and equivalent current $I_{eq}$, are obtained as follows:

$$V_{pol} = -2 \cdot [-V_2 + I_2 \cdot (Z_{S1} + Z_{L1})]$$

$$V_{eq} = V_1 - V_2 = j\frac{\sqrt{3}}{3} \cdot (V_b - V_c)$$

$$I_{eq} = I_1 - I_2 = j\frac{\sqrt{3}}{3} \cdot (I_b - I_c)$$

- if the fault occurs in the phases CA, the values of polarisation voltage $V_{pol}$, equivalent voltage $V_{eq}$ and equivalent current $I_{eq}$, are obtained as follows:

$$V_{pol} = -a \cdot 2 \cdot [-V_2 + I_2 \cdot (Z_{S1} + Z_{L1})]$$

$$V_{eq} = a^2 \cdot V_1 - a \cdot V_2 = j\frac{\sqrt{3}}{3} \cdot (V_c - V_a)$$

$$I_{eq} = a^2 \cdot I_1 - a \cdot I_2 = j\frac{\sqrt{3}}{3} \cdot (I_c - I_a)$$

where:
**a** is equal to $1\angle 120°$, and is known in advance
- if the fault occurs in the phases BA, the values of polarisation voltage $V_{pol}$, equivalent voltage $V_{eq}$ and equivalent current $I_{eq}$, are obtained as follows:

$$V_{pol} = -a^2 \cdot 2 \cdot [-V_2 + I_2 \cdot (Z_{S1} + Z_{L1})]$$

$$V_{eq} = a \cdot V_1 - a^2 \cdot V_2 = j\frac{\sqrt{3}}{3} \cdot (V_a - V_b)$$

$$I_{eq} = a \cdot I_1 - a^2 \cdot I_2 = j\frac{\sqrt{3}}{3} \cdot (I_a - I_b)$$

$$V_{eq} = V_1$$

where:
**a** is equal to $1\angle 120°$, and is known in advance.

**14.** The distance unit of any of claims 8-11, wherein, if the fault is three-phase, the values of the polarisation voltage $V_{pol}$, equivalent voltage $V_{eq}$ and equivalent current $I_{eq}$ are obtained as follows:

$$V_{pol} = \left[-V_{1pure} + I_{1pure} \cdot (Z_{S1} + Z_{L1})\right]$$

$$V_{eq} = V_1$$

$$I_{eq} = I_1$$

where

$V_{1pure}$ is the direct sequence fault voltage at the measurement point where the prefault value has been eliminated,
$I_{1pure}$ is the direct sequence fault current at the measurement point where the prefault value has been eliminated.

15. A protection system for an electric power system comprising a distance unit according to any of claims 8-14.

a

b

c

$I_a$   $I_b$   $I_c$

$Z_f$

# FIG. 1A
(STATE OF THE ART)

$I_{a1}$

$V_{a1}$   Network (+)

$I_{a2}$

$V_{a2}$   Network (-)   $3Z_f$

$I_{a0}$

$V_{a0}$   Network (0)

# FIG. 1B
(STATE OF THE ART)

# FIG. 2A
(STATE OF THE ART)

# FIG. 2B
(STATE OF THE ART)

# FIG. 3A
(STATE OF THE ART)

# FIG. 3B
(STATE OF THE ART)

# FIG. 4A
(STATE OF THE ART)

# FIG. 4B
(STATE OF THE ART)

**FIG. 5**

**FIG. 6**

**FIG. 7A**

**FIG. 7B**

EP 4 779 329 A1

**FIG. 8**

**FIG. 9**

**FIG. 10**

**FIG. 11**

**FIG. 12**

**FIG. 13**

**FIG. 14**

**FIG. 15**

## INTERNATIONAL SEARCH REPORT

| | International application No |
|---|---|
| | PCT/ES2023/070559 |

**A. CLASSIFICATION OF SUBJECT MATTER**
INV.  G01R31/08
ADD.

According to International Patent Classification (IPC) or to both national classification and IPC

**B. FIELDS SEARCHED**

Minimum documentation searched (classification system followed by classification symbols)

G01R

Documentation searched other than minimum documentation to the extent that such documents are included in the fields searched

Electronic data base consulted during the international search (name of data base and, where practicable, search terms used)

EPO-Internal, WPI Data

**C. DOCUMENTS CONSIDERED TO BE RELEVANT**

| Category* | Citation of document, with indication, where appropriate, of the relevant passages | Relevant to claim No. |
|---|---|---|
| A | US 5 839 093 A (NOVOSEL DAMIR [US] ET AL) 17 November 1998 (1998-11-17) column 14, line 49 - column 14, line 52; figures 3-6 column 16, line 20 - column 16, line 67 ----- | 1-15 |
| A | US 2017/315168 A1 (BENMOUYAL GABRIEL [CA] ET AL) 2 November 2017 (2017-11-02) paragraph [0027] - paragraph [0031]; figure 1 ----- -/-- | 1-15 |

| [x] | Further documents are listed in the continuation of Box C. | | [x] | See patent family annex. |

* Special categories of cited documents :

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance;; the claimed invention cannot be considered novel or cannot be considered to involve an inventive step when the document is taken alone

"Y" document of particular relevance;; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 21 March 2024 | 10/05/2024 |

| Name and mailing address of the ISA/ European Patent Office, P.B. 5818 Patentlaan 2 NL - 2280 HV Rijswijk Tel. (+31-70) 340-2040, Fax: (+31-70) 340-3016 | Authorized officer O'Callaghan, D |

Form PCT/ISA/210 (second sheet) (April 2005)

page 1 of 2

## INTERNATIONAL SEARCH REPORT

International application No

PCT/ES2023/070559

| C(Continuation). DOCUMENTS CONSIDERED TO BE RELEVANT | | |
|---|---|---|
| Category* | Citation of document, with indication, where appropriate, of the relevant passages | Relevant to claim No. |
| A | PATHIRIKKAT GOPAKUMAR ET AL: "Transmission line fault detection and localisation methodology using PMU measurements", IET GENERATION, TRANSMISSION&DISTRIBUTION, IET, UK, vol. 9, no. 11, 1 August 2015 (2015-08-01) , pages 1033-1042, XP006102359, ISSN: 1751-8687, DOI: 10.1049/IET-GTD.2014.0788 the whole document ----- | 1-15 |
| A | MA JING ET AL: "A Novel Line Protection Scheme for a Single Phase-to-Ground Fault Based on Voltage Phase Comparison", IEEE TRANSACTIONS ON POWER DELIVERY, IEEE SERVICE CENTER, NEW YORK, NY, US, vol. 31, no. 5, 1 October 2016 (2016-10-01), pages 2018-2027, XP011623684, ISSN: 0885-8977, DOI: 10.1109/TPWRD.2015.2507600 [retrieved on 2016-09-21] the whole document ----- | 1-15 |

Form PCT/ISA/210 (continuation of second sheet) (April 2005)

page 2 of 2

# EP 4 779 329 A1

## INTERNATIONAL SEARCH REPORT
### Information on patent family members

| Patent document cited in search report | | Publication date | Patent family member(s) | | Publication date |
| --- | --- | --- | --- | --- | --- |
| US 5839093 | A | 17-11-1998 | AU | 5324498 A | 31-07-1998 |
| | | | DE | 19782226 T1 | 02-12-1999 |
| | | | GB | 2334635 A | 25-08-1999 |
| | | | TW | 437138 B | 28-05-2001 |
| | | | US | 5839093 A | 17-11-1998 |
| | | | WO | 9829752 A1 | 09-07-1998 |
| | | | ZA | 9711639 B | 25-06-1998 |
| US 2017315168 | A1 | 02-11-2017 | US | 2017315168 A1 | 02-11-2017 |
| | | | US | 2019146024 A1 | 16-05-2019 |

Form PCT/ISA/210 (patent family annex) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3361272 A1

**Non-patent literature cited in the description**

- **CHENXU CHAO**. *Adaptive distance protection based on the analytical model of additional impedance for inverter-interfaced renewable power plants during asymmetrical faults*, 05 October 2022